(19) Europäisches Patentamt
European Patent Office
Office européen des brevets

(11) **EP 2 817 590 B1**

(12) **FASCICULE DE BREVET EUROPEEN**

(45) Date de publication et mention de la délivrance du brevet:
**06.01.2016 Bulletin 2016/01**

(21) Numéro de dépôt: **13710493.1**

(22) Date de dépôt: **20.02.2013**

(51) Int Cl.:
***G01C 19/72*** *(2006.01)*

(86) Numéro de dépôt international:
**PCT/FR2013/050351**

(87) Numéro de publication internationale:
**WO 2013/124584 (29.08.2013 Gazette 2013/35)**

(54) **DISPOSITIF DE MESURE À FIBRE OPTIQUE, GYROMÈTRE, CENTRALE DE NAVIGATION ET DE STABILISATION INERTIELLE**

FASEROPTISCHE MESSUNGSVORRICHTUNG, GYROMETER UND NAVIGATIONS- SOWIE TRÄGHEITSSTABILISIERUNGSSYSTEM

FIBER-OPTIC MEASUREMENT DEVICE, GYROMETER, AND NAVIGATION AND INERTIAL-STABILIZATION SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.02.2012 FR 1251541**

(43) Date de publication de la demande:
**31.12.2014 Bulletin 2015/01**

(73) Titulaire: **Ixblue**
**78160 Marly Le Roi (FR)**

(72) Inventeurs:
• LEFEVRE, Hervé
  F-75007 Paris (FR)
• PHAM, Van-Dong
  F-94270 Le Kremlin Bicetre (FR)
• HONTHAAS, Joachim
  F-75017 Paris (FR)

(74) Mandataire: **Coralis Harle**
**14-16 Rue Ballu**
**75009 Paris (FR)**

(56) Documents cités:
EP-A1- 0 168 292    EP-A1- 0 430 747
EP-A1- 0 455 530    EP-A2- 1 835 258
WO-A1-2012/008955   FR-A1- 2 899 681

• XUYOU LI ET AL: "Four-state modulation in fiber optic gyro", MECHATRONICS AND AUTOMATION, 2008. ICMA 2008. IEEE INTERNATIONAL CONFERENCE ON, IEEE, PISCATAWAY, NJ, USA, 5 août 2008 (2008-08-05), pages 189-192, XP031435804, DOI: 10.1109/ICMA. 2008.4798749 ISBN: 978-1-4244-2631-7

• SHITONG CHEN ET AL: "Research on the Digital Closed-loop Control of Fiber Optical Gyroscope", COMPUTER AND AUTOMATION ENGINEERING, 2009. ICCAE '09. INTERNATIONAL CONFERENCE ON, IEEE, PISCATAWAY, NJ, USA, 8 mars 2009 (2009-03-08), pages 103-107, XP031742088, ISBN: 978-0-7695-3569-2

EP 2 817 590 B1

**Description**

L'invention concerne un dispositif de mesure à fibre optique permettant de mesurer la variation d'un paramètre qui produit des perturbations non réciproques dans un interféromètre en anneau de SAGNAC.

L'interféromètre de SAGNAC et les phénomènes physiques qu'il met en jeu sont bien connus. On pourra par exemple consulter sur ce sujet l'ouvrage « The Fiber-Optic Gyroscope » de H. Lefèvre (Artech House, 1993).

Dans un tel interféromètre, une lame séparatrice ou tout autre dispositif séparateur divise une onde incidente en entrée de l'interféromètre en deux ondes. Les deux ondes ainsi créées sont dites « contra-propagatives ». Elles se propagent en effet en sens opposé le long d'un même chemin optique fermé, puis se recombinent en produisant des interférences lors de leur recombinaison. L'état d'interférence entre les deux ondes contra-propagatives dépend alors de la différence de phase relative entre elles. La puissance lumineuse P mesurée en sortie d'un interféromètre de SAGNAC est de la forme : $P(\Delta\phi) = P_0 [1 + \cos(\Delta\phi)]$ où $\Delta\phi$ est la différence de phase relative entre les deux ondes contra-propagatives. Ainsi, la puissance mesurée en sortie de l'interféromètre prend des valeurs entre un minimum (on parle alors frange « sombre ») et un maximum (frange « brillante ») en fonction de la valeur de la différence de phase $\Delta\phi$.

Il est connu que certains phénomènes physiques sont susceptibles d'introduire des déphasages dits non réciproques, sur les ondes contra-propagatives, engendrant ainsi une différence de phase $\Delta\phi_p$ entre ces ondes et modifiant l'état d'interférence lors de leur recombinaison. Ainsi, la mesure de ce déphasage $\Delta\phi_p$ non réciproque permet de quantifier le phénomène qui l'a engendré.

Le principal phénomène physique susceptible de créer des perturbations non réciproques est l'effet SAGNAC produit par la rotation de l'interféromètre autour d'un axe perpendiculaire au plan de son chemin optique fermé. Un second effet, l'effet FARADAY - ou effet magnéto-optique colinéaire-, est également connu comme produisant des effets non réciproques de ce type.

Il est connu qu'un interféromètre de SAGNAC peut comporter une bobine de fibre optique, de préférence monomode, et à conservation de polarisation. Les multiples tours d'une fibre optique forment un chemin optique fermé de très grande longueur, jusqu'à plusieurs kilomètres.

On définit communément une fréquence propre $f_p$ de l'interféromètre de SAGNAC. La fréquence propre $f_p$ d'un interféromètre en anneau de SAGNAC comportant une bobine de fibre optique monomode (fibre de silice d'indice de réfraction proche de 1.5 dans la gamme de longueur d'onde de fonctionnement) de 1 kilomètre de longueur est de l'ordre de 100 kilohertz (kHz). L'allongement de la longueur de bobine et donc du chemin optique a pour avantage de conférer une plus grande sensibilité à l'interféromètre.

Il a été montré par ailleurs que la précision de la mesure est améliorée par l'utilisation d'une méthode dite « *d'annulation de phase* », également appelée fonctionnement en boucle fermée, au lieu d'un fonctionnement en simple boucle ouverte.

Selon cette méthode, une différence de phase supplémentaire dite « *de contre-réaction* » $\Delta\phi_{cr}$ est introduite au moyen d'un modulateur de phase entre les deux ondes contra-propagatives, de manière à compenser le déphasage $\Delta\phi_p$ produit par le paramètre mesuré. La somme des deux déphasages $\Delta\phi_p$ et $\Delta\phi_{cr}$, est maintenue nulle, ce qui permet de faire fonctionner l'interféromètre avec une meilleure précision. La mesure du paramètre à mesurer est réalisée par l'exploitation du signal nécessaire à la production de la différence de phase de contre-réaction $\Delta\phi_{cr}$.

Cependant, la sensibilité de la réponse $P(\Delta\phi)$ de l'interféromètre au voisinage de la différence de phase nulle ($\Delta\phi = 0$) est faible, car le signal mesuré en sortie de l'interféromètre est une fonction cosinusoïdale de la différence de phase $\Delta\phi$.

Il est connu qu'il est possible de déplacer le point de fonctionnement de l'interféromètre vers un point offrant une plus grande sensibilité. Il a notamment été proposé d'introduire une modulation de différence de phase supplémentaire $\Delta\phi_b$, dite « *de mise au biais* » au moyen du modulateur de phase. La différence de phase totale $\Delta\phi_t$ entre les deux ondes contra-propagatives est égale alors à la somme des différentes différences de phase : $\Delta\phi_t = \Delta\phi_p + \Delta\phi_{cr} + \Delta\phi_b$.

Une solution simple à mettre en oeuvre pour réaliser cette mise au biais consiste en une modulation périodique en créneaux à une fréquence de modulation de mise au biais $f_b$, la modulation présentant des niveaux $+\pi/2$ et $-\pi/2$ par exemple. Cette modulation de différence de phase de mise au biais $\Delta\phi_b$ produit en sortie de l'interféromètre un signal électrique modulé périodique en créneaux à la fréquence de modulation de mise au biais $f_b$ dont l'amplitude est une fonction sinusoïdale de la somme des deux déphasages $\Delta\phi_p$ et $\Delta\phi_{cr}$, dans le cas d'une mesure en boucle fermée comme décrit précédemment. La réponse fournie par l'interféromètre de SAGNAC peut donc être exploitée avec une plus grande sensibilité.

Par ailleurs, afin d'améliorer la stabilité de la mesure d'un paramètre non réciproque au moyen d'un interféromètre de SAGNAC, le document EP0430747 propose un dispositif dans lequel la modulation de différence de phase de mise au biais $\Delta\phi_b(t)$ introduite entre les deux ondes contra-propagatives est périodique à la fréquence $f_b$.

À chaque période de la modulation, le niveau de la modulation de différence de phase $\Delta\phi_b(t)$ est ainsi égal à :

- $\phi_0$ pendant le premier quart de période,

- a $\phi_0$ pendant le deuxième quart de période,
- - $\phi_0$ pendant le troisième quart de période, et
- -a $\phi_0$ pendant le quatrième quart de période.

Les valeurs de a et de $\phi_0$ sont choisies de telle sorte qu'elles vérifient la relation : cos ( $\phi_0$ ) = cos ( a $\phi_0$ ).

Le dispositif selon le document EP0430747 comporte également un système de traitement du signal exploitant les quatre valeurs prises par le signal électrique modulé délivré par l'interféromètre au cours d'une période de modulation. Le système de traitement du signal permet alors de maintenir constant le gain de la chaîne de modulation afin de compenser les dérives lentes des différents composants du dispositifs (par exemple : variation en fonction de la température).

Pour diminuer les effets des défauts de la chaîne de modulation sur la mesure, il est connu que la fréquence de modulation de mise au biais $f_b$ doit être égale à la fréquence propre $f_p$ de l'interféromètre ou à l'un de ses multiples impairs.

En particulier, la modulation dite *« 4 états »* générée par la mise au biais décrite dans le document EP0430747 introduit des pics porteurs de défauts sur le signal électrique modulé mesuré en sortie de l'interféromètre, ces défauts étant éliminés lorsque la fréquence de modulation de mise au biais $f_b$ est égale à la fréquence propre $f_p$ de l'interféromètre de SAGNAC, ou à l'un de ses multiples impairs.

De plus, le nombre de ces pics augmente avec la fréquence de modulation de mise au biais $f_b$.

Pour diminuer le temps de réponse de l'interféromètre et s'assurer que la boucle de contre-réaction de mesure ne décroche pas dans le cas d'une variation rapide du paramètre à mesurer, on augmente la fréquence de modulation de mise au biais $f_b$. Cependant, la précision de la mesure s'en trouve sensiblement dégradée à cause d'un plus grand nombre de pics dans le signal détecté.

Le but de la présente invention est de proposer un dispositif de mesure à fibre optique dans lequel un paramètre à mesurer engendre une différence de phase entre deux ondes contra-propagatives dans lequel le temps de réponse est amélioré tout en conservant une bonne précision sur la gamme de mesure.

À cet effet, l'invention concerne un dispositif de mesure à fibre optique du type dans lequel un paramètre à mesurer engendre une différence de phase $\Delta\phi_p$ entre deux ondes contra-propagatives, comportant :

- une source lumineuse,
- un interféromètre en anneau de SAGNAC à fibre optique, de préférence monomode, comportant une bobine et un élément séparateur, dans lequel se propagent lesdites deux ondes contra-propagatives, ledit interféromètre en anneau ayant une fréquence propre $f_p$,
- un détecteur de rayonnement électromagnétique, recevant la puissance lumineuse sortant dudit interféromètre en anneau et délivrant un signal électrique modulé représentatif de la puissance lumineuse, qui est fonction de la différence de phase totale $\Delta\phi_t$ entre lesdites deux ondes contra-propagatives à la sortie dudit interféromètre en anneau,
- une chaîne de modulation apte à moduler ladite puissance lumineuse sortant dudit interféromètre en anneau, ladite chaîne de modulation comportant :

  - au moins un convertisseur numérique / analogique apte à traiter un signal numérique de commande pour délivrer un signal analogique de commande,
  - un amplificateur apte à traiter ledit signal analogique de commande pour délivrer une tension de commande de modulation $V_m(t)$,
  - au moins un modulateur de phase placé dans ledit interféromètre, qui, lorsqu'il est soumis en entrée à ladite tension de commande de modulation $V_m(t)$, est apte à générer en sortie une modulation de déphasage $\phi_m(t)$, ladite modulation de déphasage $\phi_m(t)$ introduisant entre lesdites deux ondes contra-propagatives une modulation de différence de phase $\phi_m(t)$ telle que : $\Delta\phi_m(t) = \phi_m(t) - \phi m(t-\Delta\tau_g)$, $\Delta\tau_g = 1/(2\ fp)$ étant la différence de temps de transit entre lesdites deux ondes contra-propagatives déterminée entre ledit modulateur de phase et ledit élément séparateur, et

- des moyens de traitement du signal comportant :

  - un convertisseur analogique / numérique numérisant ledit signal électrique modulé reçu du détecteur et représentatif de ladite puissance reçue pour délivrer un signal électrique numérique, et
  - une unité de traitement numérique apte à traiter ledit signal électrique numérique pour délivrer un signal fonction de ladite différence de phase $\Delta\phi_p$ et dudit paramètre à mesurer,

- des moyens de contre-réaction aptes à traiter ledit signal fonction de ladite différence de phase $\Delta\phi_p$ pour générer

un signal de contre-réaction,

- des moyens de mise au biais aptes à générer un signal de mise au biais,
- des moyens de commande de ladite chaîne de modulation aptes à traiter ledit signal de contre-réaction et ledit signal de mise au biais pour délivrer ledit signal numérique de commande en entrée de ladite chaîne de modulation, de telle sorte que ladite tension de commande de modulation $V_m(t)$ en entrée dudit modulateur de phase est la somme d'une tension de modulation de contre-réaction $V_{cr}(t)$ et d'une tension de modulation de mise au biais $V_b(t)$, ledit modulateur de phase étant apte, lorsqu'il est soumis à ladite tension de modulation de contre-réaction $V_{cr}(t)$, à générer une modulation de déphasage de contre-réaction $\phi_{cr}(t)$, ladite modulation de déphasage de contre-réaction $\phi_{cr}(t)$ introduisant une modulation de différence de phase de contre-réaction $\Delta\phi_{cr}$ entre lesdites deux ondes contra-propagatives permettant de maintenir nulle la somme de ladite différence de phase $\Delta\phi_p$ et de ladite modulation de différence de phase de contre-réaction $\Delta\phi_{cr}$, et
- des moyens d'asservissement de gain de ladite chaîne de modulation permettant de maintenir ajustée la fonction de transfert de ladite chaîne de modulation.

Selon l'invention, ledit dispositif de mesure à fibre optique est caractérisé en ce que lesdits moyens de mise au biais sont adaptés à générer ledit signal de mise au biais de telle sorte que ledit modulateur de phase génère une modulation de déphasage de mise au biais $\phi_b(t)$, lorsqu'il est soumis à ladite tension de modulation de mise au biais $V_b(t)$, ladite modulation de déphasage de mise au biais $\phi_b(t)$ étant la somme :

- d'une première composante de modulation de déphasage de mise au biais $\phi_{b1}(t)$, introduisant une première composante de modulation de différence de phase de mise au biais $\Delta\phi_{b1}(t)$ ente lesdites deux ondes contra-propagatives, ladite première composante de modulation de différence de phase de mise au biais $\Delta\phi_{b1}(t)$ étant une modulation périodique en créneaux, de niveaux $+\pi$ et $-\pi$, à une première fréquence de modulation de mise au biais $f_{b1}$ telle que $f_{b1} = (2k_1+1) f_p$, $k_1$ étant un nombre entier naturel, et $f_p$ ladite fréquence propre, et
- d'une seconde composante de modulation de déphasage de mise au biais $\phi_{b2}(t)$, introduisant une seconde composante de modulation de différence de phase de mise au biais $\Delta\phi_{b2}(t)$ entre lesdites deux ondes contra-propagatives, ladite seconde composante de modulation de différence de phase de mise au biais $\Delta\phi_{b2}(t)$ étant une modulation périodique, d'amplitudes extrémales $+\pi/a$ et $-\pi/a$, a étant un nombre réel non nul tel quel $|a| > 1$, à une seconde fréquence de modulation de mise au biais $f_{b2}$ telle que $f_{b2} = (2k_2+1) f_p$, $k_2$ étant un nombre entier naturel non nul tel que $k_2 > k_1$, et $f_p$ ladite fréquence propre.

Ainsi, ledit dispositif selon l'invention permet de réaliser une *« mise au biais »* autour de $\pi$, grâce à ladite première composante de modulation de différence de phase de mise au biais $\Delta\phi_{b1}(t)$ offrant un rapport signal à bruit optimal pour la chaîne de détection. Ledit dispositif permet également d'augmenter la fréquence de démodulation du signal fonction de ladite différence de phase $\Delta\phi_p$ et dudit paramètre à mesurer grâce à ladite seconde composante de modulation de différence de phase de mise au biais $\Delta\phi_{b2}(t)$ pour diminuer le temps de réponse de l'interféromètre sans pour autant augmenter le nombre de pics gênants dans le signal électrique modulé. La stabilité de la boucle fermée en est donc améliorée, c'est-à-dire que le dispositif de mesure selon l'invention est capable de mesurer un paramètre engendrant un effet non réciproque, même si ledit paramètre à mesurer varie très rapidement.

Par ailleurs, d'autres caractéristiques avantageuses et non limitatives du dispositif selon l'invention sont les suivantes :

- ladite première composante de modulation de différence de phase de mise au biais $\Delta\phi_{b1}(t)$ présente un rapport cyclique de 50% ;
- ladite seconde composante de modulation de différence de phase de mise au biais $\Delta\phi_{b2}(t)$ présente un rapport cyclique de 50% ;
- la première fréquence de modulation de mise au biais $f_{b1}$ de ladite première composante de modulation de différence de phase de mise au biais $\Delta\phi_{b1}(t)$ est telle que $k_1 = 0$ ;
- la seconde fréquence de modulation de mise au biais $f_{b2}$ de ladite seconde composante de modulation de différence de phase de mise au biais $\Delta\phi_{b2}(t)$ est telle que $k_2 > 2$ ;
- la seconde fréquence de modulation de mise au biais $f_{b2}$ de ladite seconde composante de modulation de différence de phase de mise au biais $\Delta\phi_{b2}(t)$ est telle que $k_2 > 4$ ;
- ladite seconde composante de modulation de différence de phase de mise au biais $\Delta\phi_{b2}(t)$ est une modulation en créneaux ;
- ladite seconde composante de modulation de différence de phase de mise au biais $\Delta\phi_{b2}(t)$ est une modulation sinusoïdale ;
- ladite seconde fréquence de modulation de mise au biais $f_{b2} = (2k_2+1) f_p$ est telle que $f_{b2} = (2k_{21}+1)f_{b1}$, $k_{21}$ étant un entier naturel non nul, et $f_{b1} = (2k_1+1) f_p$ étant la première fréquence de modulation de mise au biais, et ladite première composante de modulation de différence de phase de mise au biais $\Delta\phi_{b1}(t)$ et ladite seconde composante de modulation de différence de phase de mise au biais $\Delta\phi_{b2}(t)$ sont en quadrature ;

- ladite modulation de déphasage de contre-réaction $\phi_{cr}(t)$ est une modulation en marches d'escalier ;
- ladite modulation de déphasage de contre-réaction $\phi_{cr}(t)$ et ladite première composante de modulation de déphasage de mise au biais $\phi_{b1}(t)$ sont synchrones, chaque marche d'escalier de ladite modulation de déphasage de contre-réaction $\phi_{cr}(t)$ ayant une durée $\Delta\tau_g$ et ladite première composante de modulation de déphasage de mise au biais $\phi_{b1}(t)$ étant à une première fréquence de modulation de mise au biais $f_{b1}$ telle que $f_{b1} = f_p$, $f_p$ étant la fréquence propre.
- ladite modulation de déphasage de contre-réaction $\phi_{cr}(t)$ retombe de $2\pi$ lorsqu'elle dépasse $2\pi$.
- ladite unité de traitement numérique démodule ledit signal électrique numérique en phase avec ladite seconde composante de modulation de différence de phase de mise au biais $\Delta\phi_{b2}(t)$ indépendamment de la première composante de modulation de différence de phase de mise au biais $\Delta\phi_{b1}(t)$, et lesdits moyens d'asservissement de gain de ladite chaîne de modulation démodulent ledit signal électrique numérique de manière à fournir un signal fonction de la fonction de transfert de ladite chaîne de modulation.

Le dispositif de mesure selon l'invention est particulièrement bien adapté à la réalisation d'un gyromètre. Dans ce cas, le paramètre à mesurer est une composante de la vitesse de rotation de l'interféromètre en anneau.

Ainsi, l'invention concerne également un gyromètre, caractérisé en ce qu'il est conforme au dispositif de mesure à fibre optique selon l'invention, le paramètre à mesurer étant une composante de la vitesse de rotation de l'interféromètre en anneau.

Ce gyromètre entre avantageusement dans la réalisation de centrales de navigation ou de stabilisation inertielle.

Ainsi, l'invention propose également une centrale de navigation ou de stabilisation inertielle comportant au moins un gyromètre selon l'invention.

Des modes de réalisation de l'invention seront décrits en détail en référence aux dessins dans lesquels :

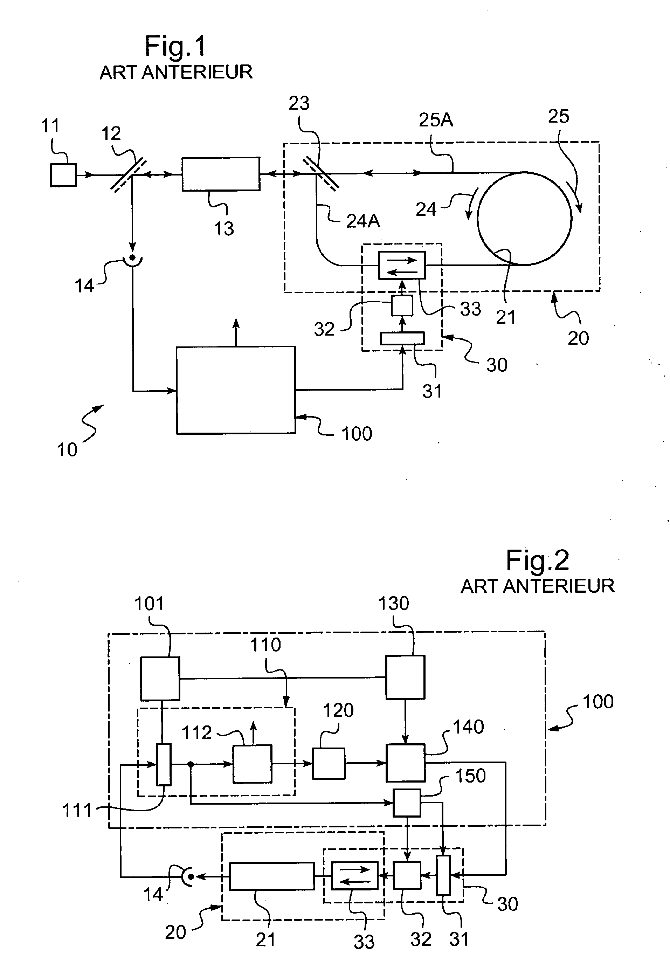

- la figure 1 représente une vue schématique du dispositif de mesure selon l'art antérieur;
- la figure 2 représente un schéma fonctionnel représentant les différents moyens mis en oeuvre dans le dispositif de mesure selon l'art antérieur ;

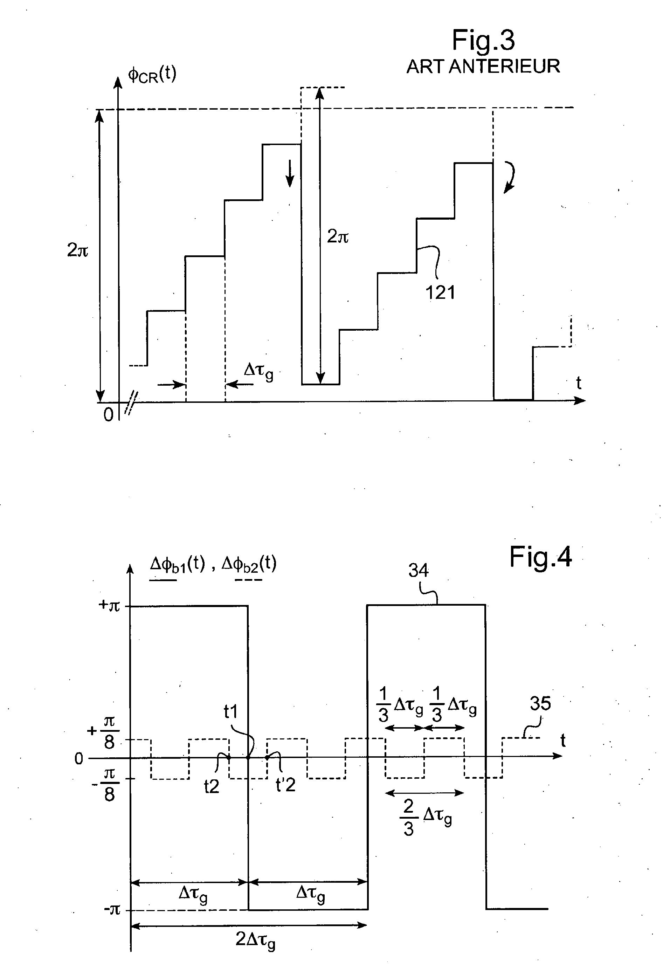

- la figure 3 représente un exemple selon l'art antérieur d'une modulation de déphasage de contre-réaction $\phi_{cr}(t)$ en marches d'escalier retombant de $2\pi$ lorsqu'elle dépasse $2\pi$ ;
- la figure 4 représente un exemple selon un mode de réalisation particulier de l'invention de première et seconde composantes de modulation de différence de phase de mise au biais $\Delta\phi_{b1}(t)$ et $\Delta\phi_{b2}(t)$ ;

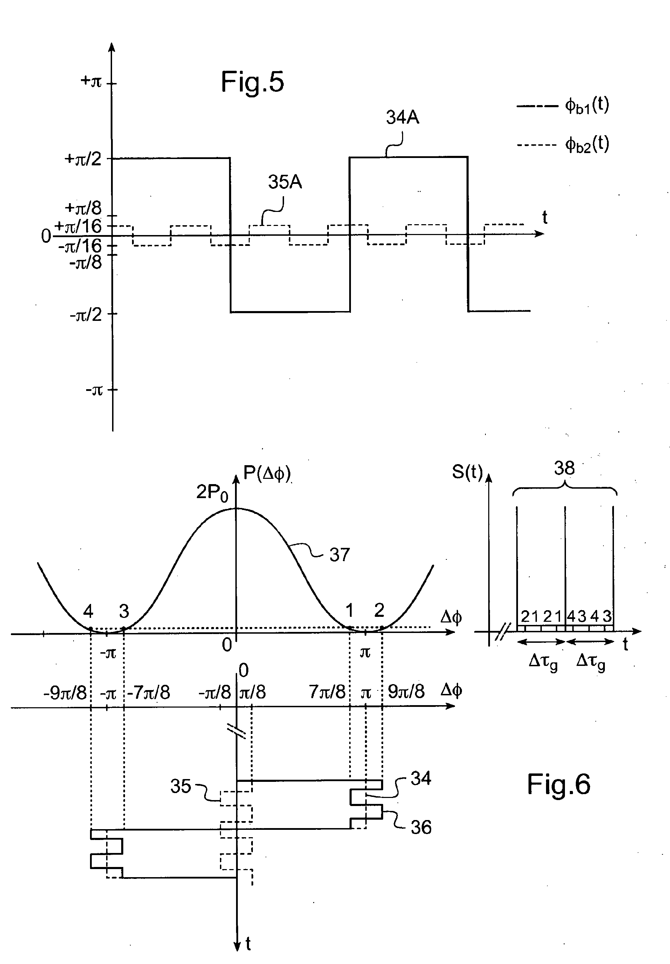

- la figure 5 représente un exemple selon un mode de réalisation particulier de l'invention de première et seconde composantes de modulation de déphasage de mise au biais $\phi_{b1}(t)$ et $\phi_{b2}(t)$ générant les première et seconde composantes de modulation de différence de phase de mise au biais $\Delta\phi_{b1}(t)$ et $\Delta\phi_{b2}(t)$ représentées sur la figure 4 ;
- la figure 6 représente un exemple de modulation de différence de phase $\Delta\phi_m(t)$ selon un mode de réalisation particulier de l'invention, la différence de phase totale en boucle ouverte dans l'interféromètre et le signal électrique modulé correspondant produit par le détecteur lorsque le paramètre à mesurer engendre une différence de phase $\Delta\phi_p$ nulle et lorsque que la fonction de transfert de la chaîne de modulation est correctement ajustée ;

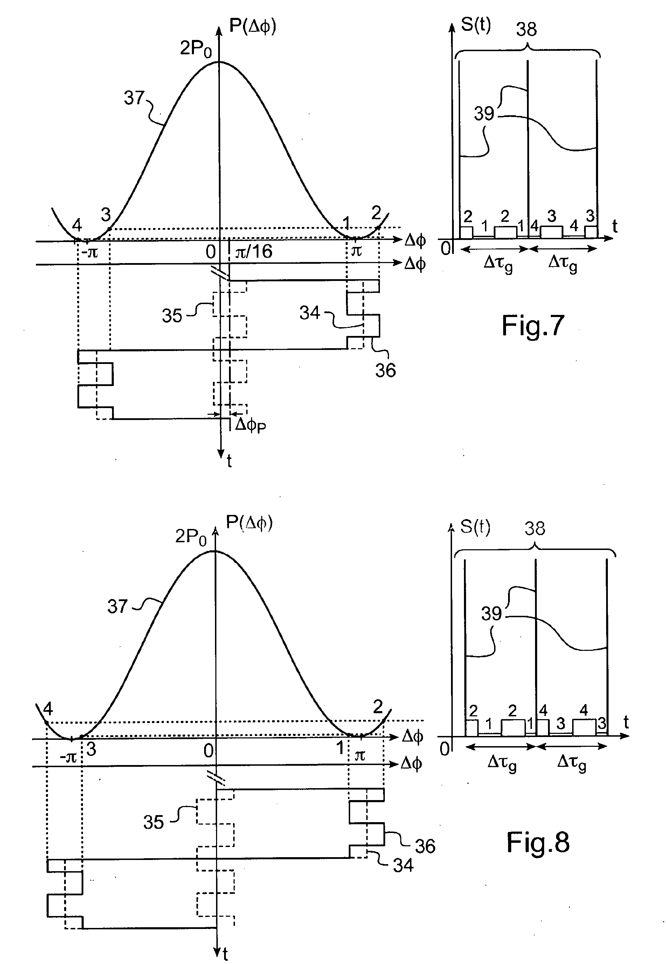

- la figure 7 représente un exemple de modulation de différence de phase $\Delta\phi_m(t)$ selon un mode de réalisation particulier de l'invention, la différence de phase totale en boucle ouverte dans l'interféromètre et le signal électrique modulé correspondant produit par le détecteur lorsque le paramètre à mesurer engendre une différence de phase $\Delta\phi_p$ non nulle et lorsque que la fonction de transfert de la chaîne de modulation est correctement ajustée ;
- la figure 8 représente un exemple de modulation de différence de phase $\Delta\phi_m(t)$ selon un mode de réalisation particulier de l'invention, la différence de phase totale en boucle ouverte dans l'interféromètre et le signal électrique modulé correspondant produit par le détecteur lorsque le paramètre à mesurer engendre une différence de phase $\Delta\phi_p$ nulle et lorsque que la fonction de transfert de la chaîne de modulation est incorrectement ajustée ;

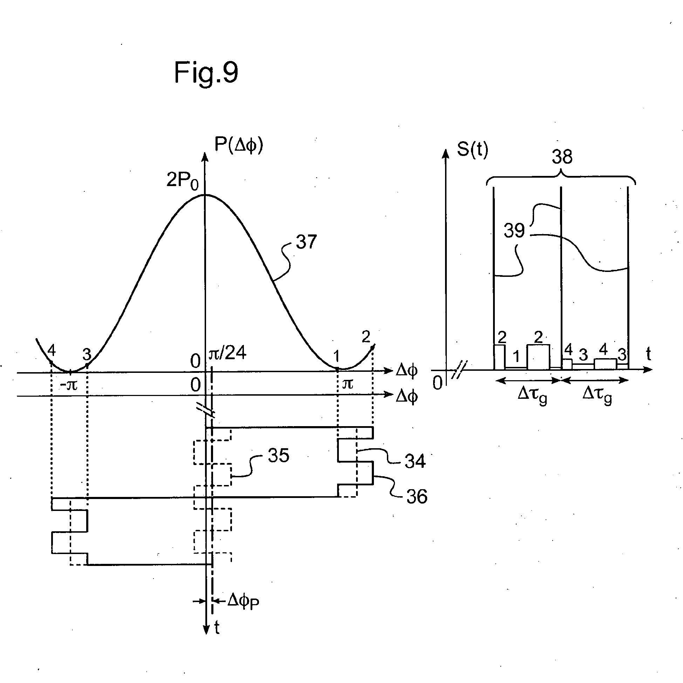

- la figure 9 représente un exemple de modulation de différence de phase $\Delta\phi_m(t)$ selon un mode de réalisation particulier de l'invention, la différence de phase totale en boucle ouverte dans l'interféromètre et le signal électrique modulé correspondant produit par le détecteur lorsque le paramètre à mesurer engendre une différence de phase $\Delta\phi_p$ non nulle et lorsque que la fonction de transfert de la chaîne de modulation est incorrectement ajustée.

La figure 1 représente un dispositif 10 de mesure à fibre optique selon l'art antérieur du type dans lequel un paramètre à mesurer engendre une différence de phase $\Delta\phi_p$ entre deux ondes.

Le dispositif 10 de mesure à fibre optique comporte tout d'abord une source lumineuse 11 comprenant ici une diode laser.

En variante, la source lumineuse peut comprendre par exemple une diode super-luminescente ou une source lumineuse à fibre dopée de type « ASE » (« *Amplified Spontaneous Emission* » en anglais).

Le dispositif 10 comprend aussi un premier élément séparateur 12. Ce premier élément séparateur 12 est ici une lame semi-réfléchissante ayant une transmittance de 50% et une réflectance de 50%.

En variante, l'élément séparateur peut être par exemple un coupleur 2x2 à 3 décibels ou un circulateur optique.

L'onde lumineuse émise par la source lumineuse 11 est ainsi transmise en partie par le premier élément séparateur 12 en direction d'un filtre optique 13 en sortie duquel l'onde lumineuse a été filtrée. Le filtre optique 13 comporte de préférence un polariseur et un filtre spatial. Ce filtre spatial est ici une fibre optique monomode, de préférence à conservation de polarisation.

Le dispositif 10 comporte également un interféromètre en anneau 20 de SAGNAC comprenant une bobine 21 d'une fibre optique enroulée sur elle-même. Il s'agit ici d'une fibre optique, de préférence de type monomode et à conservation de polarisation.

Cet interféromètre en anneau 20 de SAGNAC comprend également un second élément séparateur 23 permettant de diviser l'onde sortant du filtre optique 13 en deux ondes contra-propagatives 24, 25 sur les deux « bras » de l'interféromètre en anneau 20, ces deux bras définissant deux chemins optiques 24A et 25A. Le second élément séparateur 23 est ici une lame semi-réfléchissante ayant une transmittance de 50% et une réflectance de 50%.

Le second élément séparateur 23 permet également de recombiner les deux ondes contra-propagatives 24, 25 à la sortie de l'interféromètre en anneau 20.

En variante, le second élément séparateur peut être par exemple un coupleur 2x2 à 3 décibels ou une jonction « Y » en optique intégrée.

Les deux ondes contra-propagatives 24, 25 passent alors à travers le filtre optique 13 et sont réfléchies par le premier élément séparateur 12 en direction d'un détecteur 14 de rayonnement électromagnétique.

Ce détecteur 14 est ici une photodiode à semi-conducteur.

Le détecteur 14 est sensible à la puissance lumineuse reçue, qui est ici fonction de l'état d'interférence entre les deux ondes contra-propagatives 24, 25 lors de leur recombinaison à la sortie de l'interféromètre en anneau 20 de SAGNAC. Il délivre ainsi un signal électrique qui est représentatif de la différence de phase totale $\Delta\phi_t$ entre les deux ondes contra-propagatives 24, 25. On verra dans la suite de la description que ce signal électrique est un signal électrique modulé.

Le dispositif 10 comporte également une chaîne de modulation 30 comprenant un convertisseur numérique / analogique 31, un amplificateur 32 et un modulateur de phase 33.

Le convertisseur numérique / analogique 31 traite un signal numérique de commande délivré par les moyens de commande 140, la décomposition de ce signal étant précisée en détail par la suite. Le convertisseur numérique / analogique 31 délivre en sortie un signal analogique de commande.

L'amplificateur 32 traite alors ce signal analogique de commande pour délivrer une tension de commande de modulation $V_m(t)$ au modulateur de phase 33.

Le modulateur de phase 33 est placé dans l'interféromètre en anneau 20 et fait donc également partie de celui-ci. Il est ici disposé à une extrémité du chemin optique de l'interféromètre en anneau 20 de SAGNAC. Le modulateur de phase 33 est ici du type électro-optique (dit à *« effet Pockels »*) en optique intégrée sur niobate de lithium par échange protonique.

Le modulateur de phase 33 permet, lorsqu'on applique en son entrée la tension de commande de modulation $V_m(t)$ dépendant du temps, de générer une modulation de déphasage $\phi_m(t)$ proportionnelle et donc avec la même dépendance temporelle, sur une onde lumineuse le traversant à l'instant t donné dans un sens ou dans un autre.

Dans le cas de l'interféromètre en anneau 20 de SAGNAC représenté sur la figure 1, la différence des temps de transit des ondes contra-propagatives 24, 25 le long des deux chemins optiques 24A, 25A entre le modulateur de phase 33 et le second élément séparateur 23 est notée $\Delta\tau_g$.

Ainsi, la modulation de déphasage $\phi_m(t)$ générée par le modulateur de phase 33 commandé par la tension de commande de modulation $V_m(t)$ introduit entre les deux ondes contra-propagatives 24, 25 une modulation de différence de phase $\Delta\phi_m(t)$ telle que : $\Delta\phi_m(t) = \phi_m(t) - \phi_m(t-\Delta\tau_g)$.

La différence de temps de transit $\Delta\tau_g$ définit également une fréquence propre $f_p$ de l'interféromètre en anneau 20 de SAGNAC par la relation : $f_p = 1/(2 \Delta\tau_g)$.

Cette fréquence propre $f_p$ dépend donc de la longueur de la bobine 21 dans l'interféromètre en anneau 20 de SAGNAC. Avec la bobine 21 de fibre optique utilisée ici, bobine présentant une longueur de 1 kilomètre, la fréquence propre $f_p$ de l'interféromètre en anneau 20 de SAGNAC est d'environ 100 kilohertz (kHz), correspondant à une différence de temps de transit $\Delta\tau_g$ de 5 microsecondes ($\mu$s).

La puissance lumineuse reçue $P(\Delta\phi_t)$ par le détecteur 14 est également modulée et le signal électrique délivré par le détecteur 14 sera donc un signal électrique modulé (38), dont des exemples sont donnés sur les figures 6 à 9.

Ce signal électrique modulé 38 est transmis à des moyens électroniques 100 qui le traitent pour délivrer un signal fonction de la différence de phase $\Delta\phi_p$ et du paramètre à mesurer.

À cet effet, les moyens électroniques 100 comprennent des moyens de traitement du signal 110, tels que représentés sur la figure 2. Ces moyens de traitement du signal 110 comportent un convertisseur analogique / numérique 111 numérisant le signal électrique modulé 38 fourni par le détecteur 14 pour délivrer un signal électrique numérique.

Cette opération de numérisation est réalisée à une fréquence de synchronisation fixée par l'horloge 101. La fréquence de synchronisation de l'horloge 101 est de préférence un multiple de la fréquence propre $f_p$ de l'interféromètre en anneau 20 de SAGNAC.

Les moyens de traitement du signal 110 comprennent également une unité de traitement numérique 112 configurée pour traiter le signal électrique numérique fourni en sortie du convertisseur analogique / numérique 111. L'unité de traitement numérique 112 comporte ici un démodulateur numérique, un filtre numérique de boucle d'asservissement alimenté par un premier signal numérique démodulé sortant du démodulateur numérique et un registre.

L'unité de traitement numérique 112 délivre un signal fonction de la différence de phase $\Delta\phi_p$ et du paramètre à mesurer pour tout usage externe souhaité.

Les moyens électroniques 100 commandent également en retour la chaîne de modulation 30.

À cet effet, les moyens électroniques 100 comportent d'une part des moyens de contre-réaction 120 et d'autre part des moyens de mise au biais 130.

Les moyens de contre-réaction 120 reçoivent en entrée le signal fonction de la différence de phase $\Delta\phi_p$ du paramètre à mesurer fourni par l'unité de traitement numérique 112. En sortie, les moyens de contre-réaction 120 génèrent un signal de contre-réaction dont l'action sur la chaîne de modulation 30 sera décrite plus en détail par la suite.

Les moyens de contre-réaction 120 comportent ici un accumulateur.

Les moyens de mise au biais 130 sont configurés pour générer un signal de mise au biais à des instants précis, synchronisés par la fréquence de l'horloge 101. L'action de ce signal de mise au biais sur la chaîne de modulation 30 sera décrite plus en détail par la suite.

Les moyens électroniques 100 comportent en outre des moyens de commande 140 qui possède deux entrées et une sortie. En entrée, les moyens de commande 140 reçoivent d'une part le signal de contre-réaction et d'autre part le signal de mise au biais. Ces signaux sont ensuite traités par les moyens de commande 140. En sortie, les moyens de commande 140 délivrent un signal numérique de commande qui est alors transmis au convertisseur numérique / analogique 31 de la chaîne de modulation 30.

Les moyens de commande 140 comportent ici un additionneur numérique. L'opération effectuée par les moyens de commande 140 consiste en l'addition numérique du signal de contre-réaction fourni par les moyens de contre-réaction 120 et du signal de mise au biais fourni par les moyens de mise au biais 130. Le signal numérique de commande est le signal résultant de cette addition.

Le signal numérique de commande est alors transmis à la chaîne de modulation 30. Il est converti en un signal analogique de commande par le convertisseur numérique / analogique 31 puis transmis à l'amplificateur 32 qui délivre une tension de commande de modulation $V_m(t)$ au modulateur de phase 33.

La chaîne de modulation 30 reçoit donc en entrée le signal numérique de commande et produit en sortie au moyen du modulateur de phase 33 une modulation de déphasage $\phi_m(t)$ modulée dans le temps qui sera introduite sur les ondes contra-propagatives 24, 25 se propageant dans l'interféromètre en anneau 20 de SAGNAC.

La chaîne de modulation 30 est ainsi caractérisée électroniquement par sa fonction de transfert entre l'entrée et la sortie. Cette fonction de transfert est le rapport entre la valeur (en radians) du déphasage effectivement généré par la chaîne de modulation 30 *via* le modulateur de phase 33 et la valeur (sans unité) du signal numérique de commande transmis à la chaîne de modulation 30.

Afin de maintenir ajustée la fonction de transfert de la chaîne de modulation 30, les moyens électroniques 100 comportent aussi des moyens d'asservissement de gain 150.

Ces moyens d'asservissement de gain 150 comprennent une autre unité de traitement numérique (non représentée) exploitant le signal électrique numérique délivré par le convertisseur analogique / numérique 111 de manière à fournir un signal fonction de la fonction de transfert de la chaîne de modulation 30.

Ce signal est filtré par un filtre intégrateur numérique de boucle d'asservissement qui alimente un autre convertisseur numérique / analogique commandant le gain G variable de l'amplificateur 32 ou la tension analogique de référence du convertisseur numérique / analogique 31. Ainsi, la fonction de transfert de la chaîne de modulation 30 est maintenue correctement ajustée , ainsi que la tension de commande de modulation $V_m(t)$ délivrée par l'amplificateur 32 au modulateur de phase 33.

On entend par là qu'une valeur donnée du signal numérique de commande en entrée de la chaîne de modulation 30 donnera toujours la même valeur (en radians) de modulation de déphasage $\phi_m$ générée par le modulateur de phase 33, et ainsi la même valeur (en radians) de modulation de différence de phase $\Delta\phi_m$ introduite entre les deux ondes contra-propagatives 24, 25 dans l'interféromètre en anneau 20 de SAGNAC.

Le signal numérique de commande étant la somme du signal de contre-réaction et du signal de mise au biais, la tension de commande de modulation $V_m(t)$ en entrée du modulateur de phase 33 se décompose en la somme d'une tension de modulation de contre-réaction $V_{cr}(t)$ et d'une tension de modulation de mise au biais $V_b(t)$.

La tension de modulation de contre-réaction $V_{cr}(t)$ en entrée du modulateur de phase 33 entraîne en sortie du modulateur de phase 33 une modulation de déphasage de contre-réaction $\phi_{cr}(t)$ sur une onde le traversant.

Dans le cas de l'interféromètre en anneau 20 de SAGNAC, l'effet de cette modulation de déphasage de contre-

réaction $\phi_{cr}(t)$ est l'introduction d'une modulation de différence de phase de contre-réaction $\Delta\phi_{cr}(t)$ entre les deux ondes contra-propagatives 24, 25, permettant de compenser la différence de phase $\Delta\phi_p$ engendrée par le paramètre à mesurer et donc de maintenir nulle la somme de la différence de phase $\Delta\phi_p$ et de la différence de phase $\Delta\phi_{cr}$.

Cette contre-réaction permet de faire fonctionner le dispositif 10 en boucle fermée afin d'atteindre une bonne linéarité et stabilité de la mesure du paramètre engendrant la différence de phase $\Delta\phi_p$.

Selon l'art antérieur, la figure 3 est relative à la modulation de déphasage de contré-réaction $\phi_{cr}(t)$ générée par le modulateur de phase 33 à partir de la tension de modulation de contre-réaction $V_{cr}(t)$.

Le signal de contre-réaction généré par les moyens de contre-réaction 120 est un signal numérique en marches d'escalier.

Pour un interféromètre en anneau 20 de SAGNAC, de fréquence propre $f_p$, l'art antérieur enseigne une durée de $\Delta\tau_g$ pour chaque marche, le passage d'une marche à une autre étant synchronisée grâce à l'horloge 101 présente dans les moyens électroniques 100.

Ceci se traduit sur la figure 3 au niveau de la modulation de déphasage de contre-réaction $\phi_{cr}(t)$ qui est une modulation en marches d'escalier. Comme mentionné précédemment, l'art antérieur enseigne que la durée des marches de la modulation de déphasage de contre-réaction $\phi_{cr}(t)$ est égale à $\Delta\tau_g$.

De même, comme décrit précédemment, la hauteur de la marche est telle que la modulation de différence de phase $\Delta\phi_{cr}(t)$ introduite entre les deux ondes contra-propagatives 24, 25 compense la différence de phase $\Delta\phi_p$ due au paramètre mesuré.

Par ailleurs, la modulation de déphasage de contre-réaction $\phi_{cr}(t)$ est une modulation de rampe en marche d'escaliers telle que cette modulation retombe de $2\pi$, comme représenté sur la figure 3, lorsque la valeur de la marche dépasse $2\pi$.

Il est connu que cette « *retombée à 2π*» est rendu nécessaire par le fait que la valeur de la tension de modulation de contre-réaction $V_{cr}(t)$ ne peut pas croître indéfiniment. L'utilisation de moyens numériques, tels que le convertisseur numérique / analogique 31 permet de réaliser simplement cette retombée à $2\pi$.

Comme indiqué précédemment, les moyens de mise au biais 130 sont configurés pour générer un signal de mise au biais, ce signal de mise au biais étant transmis aux moyens de commande 140 pilotant la chaîne de modulation 30.

Ce signal de mise au biais est associé à la tension de modulation de mise au biais $V_b(t)$, au travers du convertisseur numérique / analogique 31 et de l'amplificateur 32.

Cette tension de modulation de mise au biais $V_b(t)$ en sortie de l'amplificateur 32 et en entrée du modulateur de phase 33 entraîne en sortie du modulateur de phase 33 une modulation de déphasage de mise au biais $\phi_b(t)$ sur une onde le traversant.

Dans le cas de l'interféromètre en anneau 20 de SAGNAC, l'effet de cette modulation de déphasage de mise au biais $\phi_b(t)$ est l'introduction d'une modulation de différence de phase de mise au biais $\Delta\phi_b(t)$ entre les deux ondes contra-propagatives 24, 25.

La tension de commande de modulation $V_m(t)$ en entrée du modulateur de phase 33 se décomposant en la somme de la tension de modulation de contre-réaction $V_{cr}(t)$ et de la tension de modulation de mise au biais $V_b(t)$, la modulation de déphasage $\phi_m(t)$ (respectivement la modulation de différence de phase $\Delta\phi_m(t)$), est la somme de la modulation de déphasage de contre-réaction $\phi_{cr}(t)$ (respectivement de la modulation de différence de phase de contre-réaction $\Delta\phi_{cr}(t)$) et de la modulation de déphasage de mise au biais $\phi_b(t)$ (respectivement de la modulation de différence de phase de mise au biais $\Delta\phi_b(t)$), de sorte que : $\phi_m(t) = \phi_{cr}(t) + \phi_b(t)$, et $\Delta\phi_m(t) = \Delta\phi_{cr}(t) + \Delta\phi_b(t)$.

Selon l'invention, la modulation de déphasage de mise au biais $\phi_b(t)$ est la somme :

- d'une première composante de modulation de déphasage de mise au biais $\phi_{b1}(t)$, et
- d'une seconde composante de modulation de déphasage de mise au biais $\phi_{b2}(t)$.

À cet effet, les moyens de mise au biais 130 sont agencés de manière à ce que le signal numérique de mise au biais soit la somme d'une première composante de mise au biais et d'une seconde composante de mise au biais.

La première composante de mise au biais est associée à une première composante de tension $V_{b1}(t)$, au travers du convertisseur numérique / analogique 31 et de l'amplificateur 32.

De même, la seconde composante de mise au biais est associée à une seconde composante de tension $V_{b2}(t)$, au travers du convertisseur numérique / analogique 31 et de l'amplificateur 32.

Ainsi, la tension de modulation de mise au biais $V_b(t)$ se décompose en la somme d'une première composante de tension $V_{b1}(t)$ et d'une seconde composante de tension $V_{b2}(t)$, générées au travers de l'amplificateur 32 et du convertisseur numérique / analogique 31 respectivement à partir de la première composante de mise au biais et de la seconde composante de mise au biais.

Selon l'invention, la première composante de modulation de déphasage de mise au biais $\phi_{b1}(t)$ 35A, générée à partir de la première composante de tension $V_{b1}(t)$ grâce au modulateur de phase 33, introduit une première composante de modulation de différence de phase de mise au biais $\Delta\phi_{b1}(t)$ ente les ondes contra-propagatives 24, 25 de l'interféromètre en anneau 20 de SAGNAC.

Selon l'invention, cette première composante de modulation de différence de phase de mise au biais $\Delta\phi_{b1}(t)$ est une modulation périodique en créneaux à une première fréquence de modulation de mise au biais $f_{b1}$ telle que $f_{b1}$ = $(2k_1+1) f_p$, $k_1$ étant un entier naturel et $f_p$ la fréquence propre.

Selon un mode de réalisation préféré de l'invention, la première fréquence de modulation de mise au biais $f_{b1}$ est ici égale à la fréquence propre $f_p$ ($k_1$ = 0) de l'interféromètre en anneau 20 de SAGNAC.

En variante, la première fréquence de modulation de mise au biais $f_{b1}$ peut être par exemple un multiple impair de la fréquence propre $f_p$. tel que $k_1 > 0$.

Un exemple de cette première composante de modulation de différence de phase de mise au biais $\Delta\phi_{b1}(t)$ est représenté et référencé 34 sur la figure 4.

Selon l'invention, la première composante de modulation de différence de phase de mise au biais $\Delta\phi_{b1}(t)$ 34 présente des niveaux extrêmes de valeur $+\pi$ et $-\pi$. On appellera donc par la suite *« modulation $\pi$ »* cette première composante de modulation.

Dans un mode de réalisation préféré de l'invention, cette modulation $\pi$, référencée 34 présente ici un rapport cyclique de 50%, c'est-à-dire que la durée du niveau $+\pi$ (respectivement du niveau $-\pi$) représente 50% (respectivement 50%) de la durée totale de la période de la modulation $\pi$, référencée 34.

La première fréquence de modulation de mise au biais $f_{b1}$ étant ici égale à la fréquence propre $f_p = 1/(2 \Delta\tau_g)$ de l'interféromètre en anneau 20 de SAGNAC, la période de la modulation $\pi$, référencée 34 est égale à $1 / f_{b1} = 2 \Delta\tau_g$, la modulation $\pi$, référencée 34, restant sur son niveau $+\pi$ pendant une demi-période de durée $\Delta\tau_g$, et sur son niveau $-\pi$ pendant une autre demi-période de durée $\Delta\tau_g$.

La première composante de tension $V_{b1}(t)$ produit une première composante de modulation de déphasage de mise au biais $\phi_{b1}(t)$ 34A telle que représenté sur la figure 5. Le modulateur de phase 33 étant un modulateur réciproque, l'interféromètre en anneau 20 de SAGNAC se comporte comme une ligne à retard entre les deux ondes contra-propagatives 24, 25 de telle sorte que la première composante de modulation de différence de phase de mise au biais $\Delta\phi_{b1}(t)$ 34 vérifie la relation : $\Delta\phi_{b1}(t) = \phi_{b1}(t) - \phi_{b1}(t-\Delta\tau_g)$.

On comprend ainsi comment est générée la première composante de modulation de différence de phase de mise au biais $\Delta\phi_{b1}(t)$ 34, représentée sur la figure 4, à partir de la première composante de modulation de déphasage de mise au biais $\phi_{b1}(t)$ 34A, représentée sur la figure 5.

Dans un mode de réalisation particulier de l'invention où chaque marche d'escaliers de la modulation de déphasage de contre-réaction $\phi_{cr}(t)$ a une durée $\Delta\tau_g$, la modulation de déphasage de contre-réaction $\phi_{cr}(t)$ créée au travers de la chaîne de modulation 30 est synchrone avec la première composante de modulation de déphasage de mise au biais $\phi_{b1}(t)$ qui est ici à la fréquence propre $f_p$.

On définira ici que la modulation de déphasage de contre-réaction $\phi_{cr}(t)$ et la première composante de modulation de déphasage de mise au biais $\phi_{b1}(t)$ sont en phase lorsque le passage d'une marche à une autre de la modulation de déphasage de contre-réaction $\phi_{cr}(t)$ intervient lors d'une transition de la première composante de modulation de déphasage de mise au biais $\phi_{b1}(t)$ d'un niveau extrême à un autre.

Selon ce mode de réalisation particulier, la retombée à $2\pi$ de la modulation de déphasage de contre-réaction $\phi_{cr}(t)$ est ainsi synchronisée avec une transition de la modulation $\pi$, référencée 34.

Selon l'invention, la seconde composante de modulation de déphasage de mise au biais $\phi_{b2}(t)$, générée à partir de la seconde composante de tension $V_{b2}(t)$ grâce au modulateur de phase 33, introduit une seconde composante de modulation de différence de phase de mise au biais $\Delta\phi_{b2}(t)$ ente les ondes contra-propagatives 24, 25 de l'interféromètre en anneau 20 de SAGNAC.

Selon l'invention, cette seconde composante de modulation de différence de phase de mise au biais $\Delta\phi_{b1}(t)$ est une modulation périodique à une seconde fréquence de modulation de mise au biais $f_{b2}$.telle que $f_{b2} = (2k_2+1) f_p$, $k_2$ étant un entier naturel non nul tel que $k_2 > k_1$ et $f_p$ étant la fréquence propre.

La seconde fréquence de modulation de mise au biais $f_{b2}$ est ainsi une fréquence strictement supérieure à la première fréquence de modulation de mise au biais $f_{b1}$.

Selon un mode de réalisation particulier de l'invention, la seconde fréquence de modulation de mise au biais $f_{b2}$ est telle que $f_{b2} = 3 f_p$ (*i.e.* $k_2$=1). Elle est donc bien strictement supérieure à la première fréquence de modulation de mise au biais $f_{b1}$ qui est ici telle que $f_{b1} = f_p$.

Dans un autre mode de réalisation, la seconde fréquence de modulation de mise au biais $f_{b2}$ est préférentiellement telle que $k_2 > 2$, et encore plus préférentiellement telle que $k_2 > 4$.

Selon un mode de réalisation particulier de l'invention, la seconde composante de modulation de différence de phase de mise au biais $\Delta\phi_{b2}(t)$ est ici une modulation en créneaux.

Un exemple de cette seconde composante de modulation de différence de phase de mise au biais $\Delta\phi_{b2}(t)$, est représenté et référencé 35 sur la figure 4. On observe que la seconde composante de modulation de différence de phase de mise au biais $\Delta\phi_{b2}(t)$ 35 présente, dans cet exemple, des niveaux extrêmes de valeur $+\pi/8$ et $-\pi/8$. On appellera donc par la suite *« modulation $\pi/8$ »* la seconde composante de modulation de cet exemple.

De manière générale, la seconde composante de modulation de différence de phase de mise au biais $\Delta\phi_{b2}(t)$ peut présenter des niveaux extrêmes de valeurs $+\pi/a$ et $-\pi/a$, a étant un nombre réel vérifiant la condition $|a| > 1$. La seconde composante de modulation est alors appelée de manière générale « *modulation $\pi/a$* ».

Comme représenté sur la figure 4, la modulation $\pi/8$, référencée 35, présente de préférence un rapport cyclique de 50%, c'est-à-dire que la durée du niveau $+\pi/8$ (respectivement du niveau $-\pi/8$) représente 50% (respectivement 50%) de la durée totale de la période de la modulation $\pi/8$, référencée 35.

La seconde fréquence de modulation de mise au biais $f_{b2}$ étant ici égale à $3 f_p = 3/ (2 \Delta\tau_g)$ de l'interféromètre en anneau 20 de SAGNAC, la période de la modulation $\pi/8$, référencée 35, est égale à $1/f_{b2} = (2/3) \Delta\tau_g$, la modulation $\pi/8$, référencée 35, restant sur son niveau $+\pi/8$ pendant une demi-période de durée $(1/3) \Delta\tau_g$, et sur son niveau $-\pi/8$ pendant une autre demi-période de durée $(1/3) \Delta\tau_g$.

Selon un autre mode de réalisation de l'invention, la seconde composante de modulation de différence de phase de mise au biais $\Delta\phi_{b2}(t)$ est une modulation périodique sinusoïdale, d'amplitude $\pi/a$, tel que a est un nombre réel non nul vérifiant la condition $|a| > 1$.

La seconde tension de modulation de mise au biais $V_{b2}(t)$ produit une seconde composante de modulation de déphasage de mise au biais $\phi_{b2}(t)$ 35A telle que représentée sur la figure 5. Par analogie avec la première composante de modulation décrite ci-dessus, la seconde composante de modulation de différence de phase de mise au biais $\Delta\phi_{b2}(t)$ 35 vérifie la relation : $\Delta\phi_{b2}(t) = \phi_{b2}(t) - \Delta_{b2}(t-\Delta\tau_g)$.

On comprend ainsi comment est générée la seconde composante de modulation de différence de phase de mise au biais $\Delta\phi_{b2}(t)$ 35, représentée sur la figure 4, à partir de la seconde composante de modulation de déphasage de mise au biais $\phi_{b2}(t)$ 35A, représentée sur la figure 5.

Selon le mode de réalisation particulier décrit ci-dessus, la seconde fréquence de modulation de mise au biais $f_{b2}$ est une fréquence multiple impaire de la première fréquence de modulation de mise au biais $f_{b1}$. En effet, la première fréquence de modulation de mise au biais $f_{b1}$ étant telle que $f_{b1} = f_p$, la seconde fréquence de modulation de mise au biais $f_{b2}$ est telle que $f_{b2} = 3 f_p = 3 f_{b1} = (2k_{21}+1) f_{b1}$, avec $k_{21} = 1$.

De plus, la première composante de modulation de différence de phase de mise au biais $\Delta\phi_{b1}(t)$ 34 et la seconde composante de modulation de différence de phase de mise au biais $\Delta\phi_{b2}(t)$ 35 sont ici en quadrature.

On définira ici que la première composante de modulation de différence de phase de mise au biais $\Delta\phi_{b1}(t)$ 34 et la seconde composante de modulation de différence de phase de mise au biais $\Delta\phi_{b2}(t)$ 35 sont en quadrature lorsqu'une transition de la première composante de modulation de différence de phase de mise au biais $\Delta\phi_{b1}(t)$ 34, d'un niveau extrême à un autre intervient à égale distance de deux zéros successifs de la la seconde composante de modulation de différence de phase de mise au biais $\Delta\phi_{b2}(t)$ 35.

Comme illustré sur la figure 4, la modulation n, référencée 34 opère une transition du niveau $+\pi$ au niveau $-\pi$ à l'instant $t = t1$. De même, la modulation $\pi/8$, référencée 35 s'annule à deux instants t2 et t'2 autour de la transition considérée de la modulation $\pi$, référencée 34. Les modulation $\pi$, référencée 34 et modulation $\pi/8$, référencée 35 sont en quadrature car ici $|t1 - t2| = |t1 - t'2|$.

On a représenté sur les figures 6 à 9, différents fonctionnements d'un mode de réalisation particulier du dispositif selon l'invention :

- dans la figure 6, la différence de phase $\Delta\phi_p$ engendrée par le paramètre à mesurer est nulle et la fonction de transfert de la chaîne de modulation 30 est correctement ajustée,
- dans la figure 7, la différence de phase $\Delta\phi_p$ engendrée par le paramètre à mesurer est non nulle et la fonction de transfert de la chaîne de modulation 30 est correctement ajustée,
- dans la figure 8, la différence de phase $\Delta\phi_p$ engendrée par le paramètre à mesurer est nulle et la fonction de transfert de la chaîne de modulation 30 est incorrectement ajustée, et
- dans la figure 9, la différence de phase $\Delta\phi_p$ engendrée par le paramètre à mesurer est non nulle et la fonction de transfert de la chaîne de modulation 30 est incorrectement ajustée.

Sur chacune des figures 6 à 9, où $\Delta\phi = \Delta\phi_b + \Delta\phi_p$ représente la différence de phase en boucle ouverte à la sortie de l'interféromètre en anneau 20 et t représente le temps, on a représenté :

- la modulation de différence de phase de mise au biais $\Delta\phi_b(t)$ 36 qui est la somme de la première composante de modulation de différence de phase de mise au biais $\Delta\phi_{b1}(t)$ 34 et de la seconde composante de modulation de différence de phase de mise au biais $\Delta\phi_{b2}(t)$ 35,
- la puissance lumineuse reçue $P(\Delta\phi)$ 37 par le détecteur 14, et
- le signal électrique modulé $S(t)$ 38 délivré par le détecteur 14.

Pour plus de simplicité, le raisonnement est fait pour ces figures 6 à 9 sur un dispositif 10 mis en boucle ouverte. Dans ce cas, la puissance lumineuse reçue $P(\Delta\phi)$ 37 par le détecteur 14 est une fonction cosinusoïdale de la différence

de phase relative $\Delta\phi$ entre les deux ondes contra-propagatives 24, 25 dans l'interféromètre en anneau 20 de SAGNAC.

La puissance lumineuse reçue $P(\Delta\phi)$ 37 par le détecteur 14 est en effet de la forme : $P(\Delta\phi) = P_0 [1 + \cos (\Delta\phi)]$. Elle est donc nulle lorsque $\Delta\phi = +\pi$ ou $-\pi$, (car $\cos(+\pi) = \cos(-\pi) = -1$) et elle est maximale et égale à $2P_0$ lorsque $\Delta\phi = 0$ (car $\cos(0) = 1$).

Le raisonnement peut être transposé au cas de la boucle fermée.

La première composante de modulation de différence de phase de mise au biais $\Delta\phi_{b1}(t)$ 34 (modulation $\pi$) étant ici à la fréquence $f_p$ et la seconde composante de modulation de différence de phase de mise au biais $\Delta\phi_{b2}(t)$ 35 (modulation $\pi/8$) étant à la fréquence $3 f_p$, la modulation de différence de phase de mise au biais $\Delta\phi_b(t)$ 36, qui est la somme des deux modulations précédentes, est donc une modulation périodique à la fréquence propre $f_p$.

Comme décrit précédemment, la modulation $\pi$, référencée 34, présente 2 niveaux extrêmes $+\pi$ et $-\pi$ et la modulation $\pi/8$, référencée 35, présente 2 niveaux extrêmes $+\pi/8$ et $-\pi/8$, si bien que la modulation de différence de phase de mise au biais $\Delta\phi_b(t)$ présente séquentiellement 4 niveaux différents définissant 4 états de modulation différents, qui sont :

- État E1 ou état « < + - > » : lorsque la modulation $\pi$, référencée 34, est sur son niveau extrême « haut » $+\pi$ et lorsque la modulation $\pi/8$, référencée 35, est sur son niveau extrême « bas » $-\pi/8$,
- État E2 ou état « < + + > » : lorsque la modulation $\pi$, référencée 34, est sur son niveau extrême « haut » $+\pi$ et lorsque la modulation $\pi/8$, référencée 35, est sur son niveau extrême « haut » $+\pi/8$,
- État E3 ou état « < - + > » : lorsque la modulation $\pi$, référencée 34, est sur son niveau extrême « bas » $-\pi$ et lorsque la modulation $\pi/8$, référencée 35, est sur son niveau extrême « haut » $+\pi/8$,
- État E4 ou état « < - - > » : lorsque la modulation $\pi$, référencée 34, est sur son niveau extrême « bas » $-\pi$ et lorsque la modulation $\pi/8$, référencée 35, est sur son niveau extrême « bas » $-\pi/8$.

Ces 4 états de modulation E1, E2, E3, E4 distincts sont de préférence proches d'une frange sombre de l'interféromètre en anneau 20 de SAGNAC, où le rapport signal à bruit est optimal.

La puissance lumineuse reçue $P(\Delta\phi)$ 37 par le détecteur 14 est ainsi modulée suivant ces 4 états de modulation distincts et le signal électrique modulé $S(t)$ 38 délivré par le détecteur 14 prend séquentiellement 4 valeurs S1, S2, S3, et S4 associées respectivement aux 4 états de modulation E1, E2, E3, et E4.

Lorsque le paramètre à mesurer engendre une différence de phase $\Delta\phi_p$ nulle, comme c'est la cas sur la figure 6, alors les 4 niveaux de la modulation de différence de phase de mise au biais $\Delta\phi_b(t)$ 36 sont :

- Pour l'état E1 (état < + - >) :

$$\Delta\phi = \Delta\phi_b + \Delta\phi_p = \Delta\phi_b = \Delta\phi_{b1} + \Delta\phi_{b2} = +\pi - \pi/8 = 7\pi/8$$

- Pour l'état E2 (état < + + >) :

$$\Delta\phi = \Delta\phi_b + \Delta\phi_p = \Delta\phi_b = \Delta\phi_{b1} + \Delta\phi_{b2} = +\pi + \pi/8 = 9\pi/8$$

- Pour l'état E3 (état < - + >) :

$$\Delta\phi = \Delta\phi_b + \Delta\phi_p = \Delta\phi_b = \Delta\phi_{b1} + \Delta\phi_{b2} = -\pi + \pi/8 = -7\pi/8$$

- Pour l'état E4 (état < - - >) :

$$\Delta\phi = \Delta\phi_b + \Delta\phi_p = \Delta\phi_b = \Delta\phi_{b1} + \Delta\phi_{b2} = -\pi - \pi/8 = -9\pi/8$$

La puissance lumineuse reçue $P(\Delta\phi)$ 37 par le détecteur 14 étant une fonction cosinusoïdale, comme expliqué précédemment, elle est ici dans le cas de la figure 6 la même quel que soit l'état de modulation. Le détecteur 14 délivre donc un signal électrique modulé $S(t)$ 38 prenant 4 valeurs S1, S2, S3, et S4 identiques.

À partir de la situation précédente, décrite sur la figure 6, où le paramètre à mesurer engendre une différence de phase $\Delta\phi_p$ nulle, on passe à la situation décrite sur la figure 7 où le paramètre à mesurer engendre une différence de phase $\Delta\phi_p$ non nulle entre les deux ondes contra-propagatives 24, 25 dans l'interféromètre en anneau 20 de SAGNAC.

On considérera, dans l'exemple de la figure 7, que la différence de phase $\Delta\phi_p$ engendrée par le paramètre à mesurer est de $\pi/16$.

Ceci peut être représenté sur la figure 7 en « décalant » la modulation de différence de phase de mise au biais $\Delta\phi_b(t)$ 36 de la valeur $\Delta\phi_p$. Ce décalage entraîne un changement des 4 états de modulation sur lesquels est modulé le signal reçu par le détecteur 14, qui est fonction de la puissance lumineuse reçue $P(\Delta\phi)$ 37 dépendant de la différence de phase totale $\Delta\phi$ en sortie de l'interféromètre en anneau 20. Les 4 niveaux de la modulation de différence de phase de mise au biais $\Delta\phi_b(t)$ 36 associés aux 4 états de modulations sont donc désormais :

- Pour l'état E1 (état < + - >) :

$$\Delta\phi = \Delta\phi_b + \Delta\phi_p = [+\pi - \pi/8] + \pi/16 = 15\pi/16$$

- Pour l'état E2 (état < + + >) :

$$\Delta\phi = \Delta\phi_b + \Delta\phi_p = [+\pi + \pi/8] + \pi/16 = 19\pi/16$$

- Pour l'état E3 (état < - + >) :

$$\Delta\phi = \Delta\phi_b + \Delta\phi_p = [-\pi + \pi/8] + \pi/16 = -13\pi/16$$

- Pour l'état E4 (état < - - >) :

$$\Delta\phi = \Delta\phi_b + \Delta\phi_p = [-\pi - \pi/8] + \pi/16 = -17\pi/16$$

Ainsi, comme cela est visible sur la figure 7, la puissance lumineuse reçue $P(\Delta\phi)$ 37 par le détecteur 14 dans les états de modulation E1 et E4 est plus faible, et celle reçue dans les états de modulation E2 et E3 est plus forte.

Le détecteur 14 délivre alors un signal électrique modulé S(t) 38 tel que représenté sur la figure 7. Ce signal électrique modulé S(t) 38 prend séquentiellement les 4 valeurs S1, S2, S3, et S4 associées respectivement aux 4 états de modulation E1, E2, E3, et E4. Ces 4 valeurs S1, S2, S3, et S4 prises par le signal électrique modulé S(t) 38 sont ici deux à deux identiques : S1 = S4 et S2 = S3.

On remarquera également sur la figure 7 que le signal électrique modulé S(t) 38 présente des pics 39 correspondant alternativement aux transitions de l'état E1 à l'état E4 de modulation et de l'état E3 à l'état E2 de modulation, lorsque la puissance lumineuse reçue $P(\Delta\phi)$ passe par un maximum à la valeur $\Delta\phi = 0$.

Ces pics 39 sont gênants dans la mesure où ils introduisent des défauts non voulues dans le signal électrique modulé S(t) 38.

Ce signal électrique modulé S(t) 38 est ensuite numérisé par le convertisseur analogique/numérique 111 qui délivre et transmet un signal électrique numérique à l'unité de traitement numérique 112.

Ce signal électrique numérique est également modulé et prend 4 valeurs numériques $\Sigma1$, $\Sigma2$, $\Sigma3$, et $\Sigma4$ suivant les 4 états de modulations E1, E2, E3, et E4 de la modulation de différence de phase de mise au biais $\Delta\phi_b(t)$ 36 auxquelles les valeurs sont associées.

L'unité de traitement numérique 112 démodule le signal électrique numérique en phase avec la seconde composante de modulation de différence de phase de mise au biais $\Delta\phi_{b2}(t)$ 35 indépendamment de la première composante de modulation de différence de phase de mise au biais $\Delta\phi_{b1}(t)$ 34.

On entend par là que l'unité de traitement numérique 112 délivre un premier signal numérique démodulé $\Sigma_p$ à partir des 4 valeurs numériques $\Sigma1$, $\Sigma2$, $\Sigma3$, et $\Sigma4$ associées respectivement aux 4 états de modulations E1, E2, E3, et E4 en effectuant une opération de calcul du type : $\Sigma_p = -\Sigma1 + \Sigma2 + \Sigma3 - \Sigma4$ où le « poids » de chaque valeur numérique dans l'expression précédente dépend du niveau extrême de la modulation $\pi/8$, référencée 35, dans l'état de modulation associé à cette valeur numérique, mais ne dépend pas du niveau de la modulation $\pi$, référencée 34, dans cet état de modulation.

L'unité de traitement numérique 112 produit donc un premier signal numérique démodulé $\Sigma_p$ dépendant du déphasage $\Delta\phi_p$ et représentatif de la valeur du paramètre à mesurer dans l'interféromètre en anneau 20 de SAGNAC.

On remarque ici que le premier signal numérique démodulé $\Sigma_p$ est un signal à la même fréquence que la modulation $\pi/8$, référencée 35, à savoir $3\,f_p$. Néanmoins, on remarque également que les pics 39 porteurs de défauts dans le signal électrique modulé S(t) 38 transmis par le détecteur 14 apparaissent à la fréquence double de la fréquence de la modulation π, référencée 34, à savoir ici à la fréquence 2 $f_p$.

Ainsi, il est ici possible en utilisant une première composante de modulation de différence de phase de mise au biais $\Delta\phi_{b1}$(t) 34 à la fréquence $f_p$ et une seconde composante de modulation de différence de phase de mise au biais $\Delta\phi_{b2}$(t) 35 à la fréquence 3 $f_p$, d'obtenir un signal représentatif du paramètre à mesurer à une fréquence 3 $f_p$ et de limiter le nombre de pics 39 porteurs de défauts dans le signal électrique modulé S(t) 38 délivré par le détecteur 14. Le dispositif 10 peut alors détecter des variations rapides du paramètre à mesurer sans pour autant dégrader la précision de la mesure.

De manière générale, selon l'invention, le nombre de pics 39 porteurs de défauts est fonction de la première fréquence de modulation de mise au biais $f_{b1}$ de la première composante de modulation de différence de phase de mise au biais $\Delta\phi_{b1}$(t) 34 et la fréquence du signal fonction du paramètre à mesurer fourni par l'unité de traitement numérique 112 est égale à la seconde fréquence de modulation de mise au biais $f_{b2}$ de la seconde composante de modulation de différence de phase de mise au biais $\Delta\phi_{b2}$(t) 35. Ainsi, le temps de réponse du dispositif 10 de mesure à fibre optique selon l'invention est sensiblement diminué et la précision de la mesure est conservée.

Dans un fonctionnement en boucle fermée, le premier signal numérique démodulé $\Sigma_p$ sert de signal d'erreur pour asservir la différence de phase totale $\Delta\phi_t$ à zéro en compensant le déphasage non réciproque $\Delta\phi_p$ avec le déphasage opposé $\Delta\phi_{cr}$ introduit par le modulateur de phase 33 commandé par les moyens de contre-réaction 120.

Ce déphasage $\Delta\phi_{cr}$ étant généré à travers la même chaîne de modulation 30 que la modulation de différence de phase de mise au biais $\Delta\phi_b$, l'asservissement de la chaîne de modulation 30, dont on détaille le fonctionnement ci-après, permet donc d'avoir une mesure stable et contrôlée de $\Delta\phi_{cr}$, et donc finalement de $\Delta\phi_p$ qui lui est opposé et qui est le paramètre que l'on cherche à mesurer.

La figure 8 représente le cas d'un dispositif 10 de mesure à fibre optique selon un mode de réalisation particulier de l'invention, dans lequel le paramètre mesuré engendre une différence de phase $\Delta\phi_p$ nulle, et dans lequel la fonction de transfert de la chaîne de modulation 30 est incorrectement ajustée. Comme précédemment, le raisonnement est ici fait en boucle ouverte.

En pratique, la fonction de transfert qui dépend des caractéristiques à la fois du convertisseur numérique/analogique 31 *via* sa tension analogique de référence et à la fois de l'amplificateur 32 *via* son gain variable G, peut subir des variations en fonction des conditions de mesure, par exemple la température de fonctionnement du dispositif 10 ou la dérive électrique de certains composants électroniques que comportent les moyens électroniques 100. Généralement, les paramètres influençant la fonction de transfert engendrent des variations faibles et lentes de celle-ci, si bien que les moyens d'asservissement de gain 150 opèrent aisément et rapidement afin de maintenir ajustée la fonction de transfert de la chaîne de modulation 30.

Dans le cas représenté sur la figure 8, la première composante de modulation de différence de phase de mise au biais $\Delta\phi_{b1}$(t) 34 est une modulation périodique en créneaux, de niveaux extrêmes (1+ε).[π] = 16π/15 et (1+ε).[-π] = -16π/15, le paramètre ε étant une grandeur représentative de l'écart à la fonction de transfert de la chaîne de modulation 30 correctement ajustée. Ici, la fonction de transfert de la chaîne de modulation 30 est telle que le paramètre ε vaut 1/15.

En revanche, la première fréquence de modulation de mise au biais $f_{b1}$ de la première composante de modulation de différence de phase de mise au biais $\Delta\phi_{b1}$(t) 34 demeure inchangée et ici égale à la fréquence propre $f_p$.

De la même manière, comme représenté sur la figure 8, la seconde composante de modulation de différence de phase de mise au biais $\Delta\phi_{b2}$(t) 35 est une modulation ici en créneaux, de niveaux extrêmes (1+ε).[π/8] = 2π/15 et (1+ε).[-π/8] = -2π/15, périodique à une seconde fréquence de modulation de mise au biais $f_{b2}$ demeurant inchangée et égale à 3 $f_p$.

Ces changements de niveaux extrêmes de modulation a pour conséquence que la modulation de différence de phase de mise au biais $\Delta\phi_b$(t) 36 est également modifiée par le facteur multiplicatif (1+ε) = 16/15.

Ainsi, cette homothétie sur les 4 niveaux de modulation entraîne un changement des 4 états de modulation E1, E2, E3, et E4 sur lesquels est modulé le signal reçu par le détecteur 14, qui est fonction de la puissance lumineuse reçue P($\Delta\phi$) 37 dépendant de la différence de phase $\Delta\phi$ en boucle ouverte sortie de l'interféromètre en anneau 20 de SAGNAC.

Les 4 niveaux de la modulation de différence de phase de mise au biais $\Delta\phi_b$(t) 36 associés aux 4 états de modulations sont donc désormais :

- Pour l'état E1 (état < + - >) :

$$\Delta\phi = \Delta\phi_b + \Delta\phi_p = (1+\varepsilon)\ [\pi - \pi/8] = 14\pi/15$$

- Pour l'état E2 (état < + + >) :

$$\Delta\phi = \Delta\phi_b + \Delta\phi_p = (1+\epsilon)\ [\pi + \pi/8] = 18\pi/15$$

- Pour l'état E3 (état < - + >) :

$$\Delta\phi = \Delta\phi_b + \Delta\phi_p = (1+\epsilon)\ [-\pi + \pi/8] = -14\pi/15$$

- Pour l'état E4 (état < - - >) :

$$\Delta\phi = \Delta\phi_b + \Delta\phi_p = (1+\epsilon)\ [-\pi - \pi/8] = -18\pi/15$$

Ainsi, la puissance lumineuse reçue P($\Delta\phi$) 37 par le détecteur 14 dans les états de modulation E1 et E4 est identique, mais plus faible que la puissance lumineuse reçue lorsque la fonction de transfert de la chaîne de modulation 30 est correctement ajustée, comme sur les figures 7 et 8.

De même, la puissance lumineuse reçue P($\Delta\phi$) 37 par le détecteur 14 dans les états de modulation E2 et E3 est identique, mais plus forte que la puissance lumineuse reçue lorsque la fonction de transfert de la chaîne de modulation 30 est correctement ajustée, comme sur les figures 7 et 8.

Le détecteur 14 délivre alors un signal électrique modulé S(t) 38 tel que représenté sur la figure 8. Ce signal électrique modulé S(t) 38 prend séquentiellement 4 valeurs S1, S2, S3, et S4 associées respectivement aux 4 états de modulation E1, E2, E3, et E4. Ces 4 valeurs sont ici deux à deux identiques : S1 = S3 et S2 = S4.

Les 4 valeurs $\Sigma1$, $\Sigma2$, $\Sigma3$, et $\Sigma4$ du signal électrique numérique associées respectivement aux 4 états de modulation E1, E2, E3, et E4 étant aussi deux à deux identiques avec $\Sigma1 = \Sigma3$ et $\Sigma2 = \Sigma4$, le premier signal numérique démodulé $\Sigma_p$, calculé selon l'opération $\Sigma_p = -\Sigma1 + \Sigma2 + \Sigma3 - \Sigma4$, est nul, indiquant que la valeur de la différence de phase $\Delta\phi_p$ due au paramètre à mesurer est également nulle.

Par ailleurs, le signal électrique numérique délivré par le convertisseur analogique / numérique 111 est transmis aux moyens d'asservissement de gain 150 tels que représentés sur la figure 2.

Les moyens d'asservissement de gain 150 démodulent le signal électrique numérique de manière à fournir un signal fonction de la fonction de transfert de la chaîne de modulation 30.

Plus précisément, l'autre unité de traitement numérique des moyens d'asservissement de gain 150 effectuent une opération de calcul du type : $\Sigma_G = \Sigma1 - \Sigma2 + \Sigma3 - \Sigma4$, afin de produire un second signal numérique démodulé $\Sigma_G$ indépendant de la différence de phase $\Delta\phi_p$ engendrée par le paramètre à mesurer mais significatif de la fonction de transfert de la chaîne de modulation 30.

En particulier, dans le cas représenté sur la figure 8, le second signal numérique démodulé $\Sigma_G$ est non nul, la fonction de transfert de la chaîne de modulation 30 étant incorrectement ajustée.

Le second signal numérique démodulé $\Sigma_G$ sert alors de signal d'erreur pour une boucle d'asservissement de la fonction de transfert de la chaîne de modulation 30.

À cet effet, le second signal numérique démodulé $\Sigma_G$ est filtré par un filtre intégrateur numérique de bouche d'asservissement qui alimente ensuite le convertisseur numérique / analogique 31 pour commander la tension analogique de référence ou l'amplificateur 32 pour commander son gain variable G.

Ainsi, la fonction de transfert de la chaîne de modulation 30 est maintenu correctement ajustée entre la valeur du signal numérique de commande et la valeur de la modulation de déphasage effectivement appliquée par le modulateur de phase 33.

On remarquera, que dans le cas des figures 6 et 7, le second signal numérique démodulé $\Sigma_G$ est nul puisque la fonction de transfert de la chaîne de modulation 30 est correctement ajustée.

En effet, dans ce cas, on a :

- $\Sigma1 = \Sigma4$, la puissance lumineuse reçue P($\Delta\phi$) 37 reçue dans l'état E1 et dans l'état E4 étant la même, et
- $\Sigma2 = \Sigma3$, la puissance lumineuse reçue P($\Delta\phi$) 37 reçue dans l'état E2 et dans l'état E3 étant la même.

La figure 9 représente le cas d'un dispositif 10 de mesure à fibre optique selon un mode de réalisation particulier de l'invention, dans lequel le paramètre mesuré engendre une différence de phase $\Delta\phi_p$ non nulle, égale ici à $\pi/24$ et dans lequel la fonction de transfert de la chaîne de modulation 30 est incorrectement ajustée. Comme précédemment, le raisonnement est ici fait en boucle ouverte.

Dans le cas particulier de la figure 9, la fonction de transfert de la chaîne de modulation 30 est ici également telle que $\epsilon = 1/15$.

Ainsi, les 4 niveaux de la modulation de différence de phase de mise au biais $\phi\Delta_b(t)$ 36 associés aux 4 états de modulations sont donc ici :

- Pour l'état E1 (état < + - >) :

$$\Delta\phi = \Delta\phi_b + \Delta\phi_p = (1+\varepsilon)\,[\pi - \pi/8] + \pi/24 = 117\pi/120$$

- Pour l'état E2 (état < + + >) :

$$\Delta\phi = \Delta\phi_b + \Delta\phi_p = (1+\varepsilon)\,[\pi + \pi/8] + \pi/24 = 149\pi/120$$

- Pour l'état E3 (état < - + >) :

$$\Delta\phi = \Delta\phi_b + \Delta\phi_p = (1+\varepsilon)\,[-\pi + \pi/8] + \pi/24 = -107\pi/120$$

- Pour l'état E4 (état < - - >) :

$$\Delta\phi = \Delta\phi_b + \Delta\phi_p = (1+\varepsilon)\,[-\pi - \pi/8] + \pi/24 = -139\pi/120$$

Comme cela est visible sur la figure 9, le signal électrique modulé S(t) 38 prend alors 4 valeurs S1, S2, S3, et S4 qui sont toutes différentes.

Ainsi, le premier signal numérique démodulé $\Sigma_P$ représentatif de la différence de phase $\Delta\phi_p$ et du paramètre à mesurer dans l'interféromètre en anneau 20 de SAGNAC est non nul.

De même, le second signal numérique démodulé $\Sigma_G$ significatif de la fonction de transfert de la chaîne de modulation 30 est non nul, montrant que celle-ci est effectivement incorrectement ajustée.

Ainsi, la mesure de la différence de phase $\Delta\phi_p$ due au paramètre à mesurer et celle de la fonction de transfert de la chaîne de modulation (30) sont effectuées de manière indépendante.

Le dispositif de mesure de l'invention est particulièrement bien adapté à la réalisation d'un gyromètre. Dans ce cas, le paramètre à mesurer est une composante de la vitesse de rotation de l'interféromètre en anneau 20.

Ce gyromètre entre ainsi avantageusement dans la réalisation de centrales de navigation ou de stabilisation inertielle.

Une telle disposition est également bien adaptée à la réalisation d'un dispositif de mesure de champ magnétique et de courant électrique en mettant à profit l'effet FARADAY.

**Revendications**

1. Dispositif (10) de mesure à fibre optique du type dans lequel un paramètre à mesurer engendre une différence de phase $\Delta\phi_p$ entre deux ondes contra-propagatives (24, 25), comportant :

   - une source lumineuse (11),
   - un interféromètre en anneau (20) de SAGNAC à fibre optique, de préférence monomode, comportant une bobine (21) et un élément séparateur (23), dans lequel se propagent lesdites deux ondes contra-propagatives (24, 25), ledit interféromètre en anneau (20) ayant une fréquence propre $f_p$,
   - un détecteur (14) de rayonnement électromagnétique, recevant la puissance lumineuse (37) sortant dudit interféromètre en anneau (20) et délivrant un signal électrique modulé (38) représentatif de la puissance lumineuse (37), qui est fonction de la différence de phase totale $\Delta\phi_t$ entre lesdites deux ondes contra-propagatives (24, 25) à la sortie dudit interféromètre en anneau (20),
   - une chaîne de modulation (30) apte à moduler ladite puissance lumineuse (37) sortant dudit interféromètre en anneau (20), ladite chaîne de modulation (30) comportant :
   - au moins un convertisseur numérique / analogique (31) apte à traiter un signal numérique de commande pour délivrer un signal analogique de commande,
   - un amplificateur (32) apte à traiter ledit signal analogique de commande pour délivrer une tension de commande

de modulation $V_m(t)$,

- au moins un modulateur de phase (33) placé dans ledit interféromètre (20), qui, lorsqu'il est soumis en entrée à ladite tension de commande de modulation $V_m(t)$, est apte à générer en sortie une modulation de déphasage $\phi_m(t)$, ladite modulation de déphasage $\phi_m(t)$ introduisant entre lesdites deux ondes contra-propagatives (24, 25) une modulation de différence de phase $\Delta\phi_m(t)$ telle que : $\Delta\phi_m(t) = \phi_m(t) - \phi_m(t-\Delta\tau_g)$, $\Delta\tau_g = 1 / (2\ f_p)$ étant la différence de temps de transit entre lesdites deux ondes contra-propagatives (24, 25) déterminée entre ledit modulateur de phase (33) et ledit élément séparateur (23), et

- des moyens de traitement du signal (110) comportant :

  - un convertisseur analogique / numérique (111) numérisant ledit signal électrique modulé (38) reçu du détecteur (14) et représentatif de ladite puissance reçue pour délivrer un signal électrique numérique, et
  - une unité de traitement numérique (112) apte à traiter ledit signal électrique numérique pour délivrer un signal fonction de ladite différence de phase $\Delta\phi_p$ et dudit paramètre à mesurer,

- des moyens de contre-réaction (120) aptes à traiter ledit signal fonction de ladite différence de phase $\Delta\phi_p$ pour générer un signal de contre-réaction,

- des moyens de mise au biais (130) aptes à générer un signal de mise au biais,

- des moyens de commande (140) de ladite chaîne de modulation (30) aptes à traiter ledit signal de contre-réaction et ledit signal de mise au biais pour délivrer ledit signal numérique de commande en entrée de ladite chaîne de modulation (30), de telle sorte que ladite tension de commande de modulation $V_m(t)$ en entrée dudit modulateur de phase (33) est la somme d'une tension de modulation de contre-réaction $V_{cr}(t)$ et d'une tension de modulation de mise au biais $V_b(t)$, ledit modulateur de phase (33) étant apte :

  - lorsqu'il est soumis à ladite tension de modulation de contre-réaction $V_{cr}(t)$, à générer une modulation de déphasage de contre-réaction $\phi_{cr}(t)$ (121), ladite modulation de déphasage de contre-réaction $\phi_{cr}(t)$ (121) introduisant une modulation de différence de phase de contre-réaction $\Delta\phi_{cr}$ entre lesdites deux ondes contra-propagatives (24, 25) permettant de maintenir nulle la somme de ladite différence de phase $\Delta\phi_p$ et de ladite modulation de différence de phase de contre-réaction $\Delta\phi_{cr}$,
  - lorsqu'il est soumis à ladite tension de modulation de mise au biais $V_b(t)$ à générer une modulation de déphasage de mise.au biais $\phi_b(t)$, et

- des moyens d'asservissement de gain (150) de ladite chaîne de modulation (30) permettant de maintenir ajustée la fonction de transfert de ladite chaîne de modulation (30), ledit dispositif (10) de mesure à fibre optique étant **caractérisé en ce que** ladite modulation de déphasage de mise au biais $\phi_b(t)$ est la somme :

- d'une première composante de modulation de déphasage de mise au biais $\phi_{b1}(t)$ (34A), introduisant une première composante de modulation de différence de phase de mise au biais $\Delta\phi_{b1}(t)$ (34) ente lesdites deux ondes contra-propagatives (24, 25), ladite première composante de modulation de différence de phase dé mise au biais $\Delta\phi_{b1}(t)$ (34) étant une modulation périodique en créneaux, de niveaux $+\pi$ et $-\pi$, à une première fréquence de modulation de mise au biais $f_{b1}$ telle que $f_{b1} = (2k_1+1)\ f_p$, $k_1$ étant un nombre entier naturel, et $f_p$ ladite fréquence propre, et

- d'une seconde composante de modulation de déphasage de mise au biais $\phi_{b2}(t)$ (35A), introduisant une seconde composante de modulation de différence de phase de mise au biais $\Delta\phi_{b2}(t)$ (35) entre lesdites deux ondes contra-propagatives (24, 25), ladite seconde composante de modulation de différence de phase de mise au biais $\Delta\phi_{b2}(t)$ (35) étant une modulation périodique, d'amplitudes extrémales $+\pi/a$ et $-\pi/a$, a étant un nombre réel non nul tel que $|a| > 1$, à une seconde fréquence de modulation de mise au biais $f_{b2}$ telle que $f_{b2} = (2k_2+1)\ f_p$, $k_2$ étant un nombre entier naturel non nul tel que $k_2 > k_1$, et $f_p$ ladite fréquence propre.

**2.** Dispositif (10) de mesure à fibre optique selon la revendication 1, dans lequel ladite première composante de modulation de différence de phase de mise au biais $\Delta\phi_{b1}(t)$ (34) présente un rapport cyclique de 50%.

**3.** Dispositif (10) de mesure à fibre optique selon la revendication 1, dans lequel ladite seconde composante de modulation de différence de phase de mise au biais $\Delta\phi_{b2}(t)$ (35) présente un rapport cyclique due 50%.

**4.** Dispositif (10) de mesure à fibre optique selon l'une des revendication 1 à 3, dans lequel $k_1 = 0$.

**5.** Dispositif (10) de mesure à fibre optique selon l'une des revendications 1 à 4, dans lequel $k_2 > 2$.

**6.** Dispositif (10) de mesure à fibre optique selon la revendication 5, dans lequel $k_2 > 4$.

**7.** Dispositif (10) de mesure à fibre optique selon l'une des revendications 1 à 6, dans lequel ladite seconde composante de modulation de différence de phase de mise au biais $\Delta\phi_{b2}(t)$ (35) est une modulation en créneaux.

**8.** Dispositif (10) de mesure à fibre optique selon l'une des revendications 1 à 6, dans lequel ladite seconde composante de modulation de différence de phase de mise au biais $\Delta\phi_{b2}(t)$ (35) est une modulation sinusoïdale.

**9.** Dispositif (10) de mesure à fibre optique selon l'une des revendications 1 à 8, dans lequel :

- ladite seconde fréquence de modulation de mise au biais $f_{b2} = (2k_2+1) f_p$ est telle que $f_{b2} = (2k_{21}+1)f_{b1}$, $k_{21}$ étant un entier naturel non nul, et $f_{b1} = (2k_1+1) f_p$ étant la première, fréquence de modulation de mise au biais, et
- ladite première composante de modulation de différence de phase de mise au biais $\Delta\phi_{b1}(t)$ (34) et ladite seconde composante de modulation de différence de phase de mise au biais $\Delta\phi_{b2}(t)$ (35) sont en quadrature.

**10.** Dispositif (10) de mesure à fibre optique selon l'une des revendications 1 à 9, dans lequel ladite modulation de déphasage de contre-réaction $\phi_{cr}(t)$ (121) est une modulation en marche d'escaliers.

**11.** Dispositif (10) de mesure à fibre optique selon la revendication 10, dans lequel ladite modulation de déphasage de contre-réaction $\Delta_{cr}(t)$ (121) et ladite première composante de modulation de déphasage de mise au biais $\phi_{b1}(t)$ (34A) sont synchrones, chaque marche d'escaliers de ladite modulation de déphasage de contre-réaction $\phi_{cr}(t)$ (121) ayant une durée $\Delta\tau_g$ et ladite première composante de modulation de déphasage de mise au biais $\phi_{b1}(t)$ (34A) étant à une première fréquence de modulation de mise au biais $f_{b1}$ telle que $f_{b1} = f_p$, $f_p$ étant la fréquence propre.

**12.** Dispositif (10) de mesure à fibre optique selon l'une des revendications 1 à 11, dans lequel ladite modulation de déphasage de contre-réaction $\phi_{cr}(t)$ retombe de $2\pi$ lorsqu'elle dépasse $2\pi$.

**13.** Dispositif (10) de mesure à fibre optique selon l'une des revendications 1 à 12, dans lequel

- ladite unité de traitement numérique (112) démodule ledit signal électrique numérique en phase avec ladite seconde composante de modulation de différence de phase de mise au biais $\Delta\phi_{b2}(t)$ (35), indépendamment de la première composante de modulation de différence de phase de mise au biais $\Delta\phi_{b1}(t)$ (34) et
- lesdits moyens d'asservissement de gain (150) de ladite chaîne de modulation (30) démodulent ledit signal électrique numérique de manière fournir un signal fonction de la fonction de transfert de ladite chaîne de modulation (30).

**14.** Gyromètre, **caractérisé en ce qu'**il est conforme au dispositif (10) de mesure de l'une des revendications 1 à 13, le paramètre à mesurer étant une composante de la vitesse de rotation de l'interféromètre en anneau (20).

**15.** Centrale de navigation ou de stabilisation inertielle comportant au moins un gyromètre selon la revendication 14.

**Patentansprüche**

**1.** Faseroptische Meßvorrichtung (10) vom Typ, in dem ein zu messender Parameter eine Phasendifferenz $\Delta\Phi_p$ zwischen zwei entgegengesetzt laufenden Wellen (24, 25) bewirkt, mit

- einer Lichtquelle (11),
- einem SAGNAC-Ringinterferometer (20) mit optischer, vorzugsweise monomodaler Faser, das eine Spule (21) und ein Trennelement (23) aufweist, in dem sich die beiden entgegengesetzt laufenden Wellen (24, 25) ausbreiten, wobei das Ringinterferometer (20) eine Eigenfrequenz $f_p$ hat,
- einem Detektor (14) elektromagnetischer Strahlung, der die aus dem Ringinterferometer (20) austretende Lichtleistung (37) empfängt und ein moduliertes elektrisches, die Lichtleistung (37) darstellendes Signal (38) abgibt, das von der gesamten Phasendifferenz $\Delta\Phi_t$ zwischen den beiden entgegengesetzt laufenden Wellen (24, 25) am Ausgang des Ringinterferometers (20) abhängt,
- einer Modulationskette (30), die geeignet ist, die aus dem Ringinterferometer (20) austretende Lichtleistung (37) zu modulieren, wobei die Modulationskette (30)

- wenigstens einen Digital-/Analog-Wandler (31), der geeignet ist, ein digitales Steuersignal zu verarbeiten, um ein analoges Steuersignal abzugeben,

- einen Verstärker (32), der geeignet ist, das analoge Steuersignal zu verarbeiten, um eine Modulations-steuerspannung $V_m(t)$ abzugeben,
- wenigstens einen im besagten Interferometer (20) angeordneten Phasenmodulator (33), der, wenn er am Eingang mit der Modulationssteuerspannung $V_m(t)$ beaufschlagt wird, in der Lage ist, am Ausgang eine Phasenverschiebungsmodulation $\Phi_m(t)$ zu erzeugen, wobei die Phasenverschiebungsmodulation $\Phi_m(t)$ zwischen den beiden entgegengesetzt laufenden Wellen (24, 25) eine Phasendifferenzmodulation $\Delta\Phi_m(t)$ derart erzeugt, daß $\Delta\Phi_m(t) = \Phi_m(t) - \Phi_m(t-\Delta\tau_g)$, wobei $\Delta\tau_g = 1/(2\,fp)$ die Differenz der zwischen dem Phasenmodulator (33) und dem Trennelement (23) bestimmten Durchlaufzeit zwischen den beiden entgegengesetzt laufenden Wellen (24, 25) ist,

aufweist,
und
- Signalverarbeitungsmitteln (110), die

- einen Analog-/Digital-Wandler (111), der das vom Detektor (14) erhaltene und die besagte erhaltene Leistung darstellende modulierte elektrische Signal (38) digitalisiert, um ein digitales elektrisches Signal abzugeben, und
- eine digitale Verarbeitungseinheit (112), die geeignet ist, das digitale elektrische Signal zu verarbeiten, um ein Signal abzugeben, das von der Phasendifferenz $\Delta\Phi_p$ und dem zu messenden Parameter abhängt,

aufweisen,

- Rückkopplungsmitteln (120), die geeignet sind, das von der Phasendifferenz $\Delta\Phi_p$ abhängende elektrische digitale Signal zu verarbeiten, um ein Rückkopplungssignal zu erzeugen,
- Mitteln (130) für eine zusätzliche Phasendifferenzmodulation zum Bringen auf Genauigkeit, die geeignet sind, ein Signal zum Bringen auf Genauigkeit zu erzeugen,
- Mitteln (140) zum Steuern der Modulationskette (30), die geeignet sind, das Rückkopplungssignal und das Signal zum Bringen auf Genauigkeit zu verarbeiten, um das digitale Steuersignal am Eingang der Modulationskette (30) so zu liefern, daß die Modulationssteuerspannung $V_m(t)$ am Eingang des Phasenmodulators (33) die Summe aus einer Rückkopplungsmodulationsspannung $V_{cr}(t)$ und einer Modulationsspannung zum Bringen auf Genauigkeit $V_b(t)$ ist, wobei der Phasenmodulator (3) geeignet ist,

- wenn er mit der Rückkopplungsmodulationsspannung $V_{cr}(t)$ beaufschlagt ist, eine Rückkopplungspha-senverschiebungsmodulation $\Phi_{cr}(t)$ (121) zu erzeugen, wobei die Rückkopplungsphasenverschiebungs-modulation $\Phi_{cr}(t)$ (121) eine Rückkopplungsphasendifferenzmodulation $\Delta\Phi_{cr}$ zwischen den beiden entgegengesetzt laufenden Wellen (24, 25) einführt, die es ermöglicht, die Summe aus der Phasendifferenz $\Delta\Phi_p$ und der Rückkopplungsphasendifferenzmodulation $\Delta\Phi_{cr}$ auf Null zu halten,
- wenn er mit der Modulationsspannung zum Bringen auf Genauigkeit $V_b(t)$ beaufschlagt ist, eine Phasenverschiebungsmodulation zum Bringen auf Genauigkeit $\Phi_b(t)$ zu erzeugen, und

- Mitteln (150) zum Steuern der Verstärkung der Modulationskette (30), die ermöglichen, die Transferfunktion der Modulationskette (30) angepaßt zu halten,
wobei die faseroptische Meßvorrichtung (10) **dadurch gekennzeichnet ist, daß** die Phasenverschiebungsmodulation zum Bringen auf Genauigkeit $\Phi_b(t)$ die Summe aus
- einer ersten Komponente der Phasenverschiebungsmodulation zum Bringen auf Genauigkeit $\Phi_{b1}(t)$ (34A), die eine erste Phasendifferenzmodulationskomponente zum Bringen auf Genauigkeit $\Delta\Phi_{b1}(t)$ (34) zwischen den beiden entgegengesetzt laufenden Wellen (24, 25) einführt, wobei die erste Phasendifferenzmodulationskomponente zum Bringen auf Genauigkeit (34) eine periodische Rechteckmodulation mit den Niveaus $+\pi$ und $-\pi$ bei einer ersten solchen Modulationsfrequenz zum Bringen auf Genauigkeit $f_{b1}$ ist, daß $f_{b1} = (2k_1+1)f_p$ ist, wobei $k_1$ eine natürliche ganze Zahl und $f_p$ die besagte Eigenfrequenz ist, und
- einer zweiten Komponente der Phasenverschiebungsmodulation zum Bringen auf Genauigkeit $\Phi_{b2}(t)$ (35A), die eine zweite Phasendifferenzmodulationskomponente zum Bringen auf Genauigkeit $\Delta\Phi_{b2}(t)$ (35) zwischen den beiden entgegengesetzt laufenden Wellen (24, 25) einführt, wobei die zweite Phasendifferenzmodulationskomponente zum Bringen auf Genauigkeit $\Delta\Phi_{b2}(t)$ (35) eine periodische Modulation mit den Extrempli-tuden $+\pi/a$ und $-\pi/a$ ist, wobei a eine reelle, von Null verschiedene Zahl derart ist, daß $|a| > 1$ bei einer zweiten solchen Modulationsfrequenz zum Bringen auf Genauigkeit $f_{b2}$ ist, daß $f_{b2} = (2k_2+1)f_p$ ist, wobei $k_2$ eine natürliche ganze, von Null verschiedene Zahl derart ist, daß $k_2 > k_1$ und $f_p$ die besagte Eigenfrequenz ist, ist.

**2.** Faseroptische Meßvorrichtung (10) gemäß Anspruch 1, bei der die erste Phasendifferenzmodulationskomponente zum Bringen auf Genauigkeit $\Delta\Phi_{b1}(t)$ (34) ein zyklisches Verhältnis von 50 % aufweist.

**3.** Faseroptische Meßvorrichtung (10) gemäß Anspruch 1, bei der die zweite Phasendifferenzmodulationskomponente zum Bringen auf Genauigkeit $\Delta\Phi_{b2}(t)$ (35) ein zyklisches Verhältnis von 50 % aufweist.

**4.** Faseroptische Meßvorrichtung (10) gemäß einem der Ansprüche 1 bis 3, bei dem $k_1 = 0$ ist.

**5.** Faseroptische Meßvorrichtung (10) gemäß einem der Ansprüche 1 bis 4, bei dem $k_2 > 2$ ist.

**6.** Faseroptische Meßvorrichtung (10) gemäß Anspruch 5, bei dem $k_2 > 4$ ist.

**7.** Faseroptische Meßvorrichtung (10) gemäß einem der Ansprüche 1 bis 6, **dadurch gekennzeichnet, daß** die zweite Phasendifferenzmodulationskomponente zum Bringen auf Genauigkeit $\Delta\Phi_{b2}(t)$ (35) eine Rechteckmodulation ist.

**8.** Faseroptische Meßvorrichtung (10) gemäß einem der Ansprüche 1 bis 6, **dadurch gekennzeichnet, daß** die zweite Phasendifferenzmodulationskomponente zum Bringen auf Genauigkeit $\Delta\Phi_{b2}(t)$ (35) eine Sinusmodulation ist.

**9.** Faseroptische Meßvorrichtung (10) gemäß einem der Ansprüche 1 bis 8, bei der

- die zweite Modulationsfrequenz zum Bringen auf Genauigkeit $f_{b2} = (2k_{21}+1)f_p$ derart ist, daß $f_{b2} = (2k_2+1)f_{b1}$ ist, wobei $k_{21}$ eine natürliche ganze, von Null verschiedene Zahl ist und $f_{b1} = (2k_1+1)f_p$ die erste Modulationsfrequenz zum Bringen auf Genauigkeit ist, und
- die erste Phasendifferenzmodulationskomponente zum Bringen auf Genauigkeit $\Delta\Phi_{b1}(t)$ (34) und die zweite Modulationskomponente zum Bringen auf Genauigkeit $\Delta\Phi_{b2}(t)$ (35) in Quadratur sind.

**10.** Faseroptische Meßvorrichtung (10) gemäß einem der Ansprüche 1 bis 9, bei der die Rückkopplungsphasenverschiebungsmodulation $\Phi_{cr}(t)$ (121) eine Treppenstufenmodulation ist.

**11.** Faseroptische Meßvorrichtung (10) gemäß Anspruch 10, bei der die Rückkopplungsphasenverschiebungsmodulation zum Bringen auf Genauigkeit $\Phi_{cr}(t)$ (121) und die erste Komponente der Phasenverschiebungsmodulation zum Bringen auf Genauigkeit $\Phi_{b1}(t)$ (34A) synchron sind, wobei jede Treppenstufe der Rückkopplungsphasenverschiebungsmodulation zum Bringen auf Genauigkeit $\Phi_{cr}(t)$ (121) eine Dauer $\Delta\tau_g$ hat und die erste Komponente der Phasenverschiebungsmodulation zum Bringen auf Genauigkeit $\Phi_{b1}(t)$ (34A) bei einer ersten Modulationsfrequenz zum Bringen auf Genauigkeit derart ist, daß $f_{b1} = f_p$, wobei $f_p$ die Eigenfrequenz ist.

**12.** Faseroptische Meßvorrichtung (10) gemäß einem der Ansprüche 1 bis 11, bei der die Rückkopplungsphasenverschiebungsmodulation $\Phi_{cr}(t)$ um $2\pi$ zurückfällt, wenn sie $2\pi$ überschreitet.

**13.** Faseroptische Meßvorrichtung (10) gemäß einem der Ansprüche 1 bis 12, bei der

- die digitale Verarbeitungseinheit (112) das digitale elektrische Signal in Phase mit der zweiten Phasendifferenzmodulationskomponente zum Bringen auf Genauigkeit $\Delta\Phi_{b2}(t)$ (35) unabhängig von der ersten Phasendifferenzmodulationskomponente zum Bringen auf Genauigkeit $\Delta\Phi_{b1}(t)$ (34) demoduliert und
- die Mittel (150) zum Steuern der Verstärkung der Modulationskette (30) das digitale elektrische Signal derart demodulieren, daß ein Signal in Abhängigkeit von der Transferfunktion der Modulationskette (30) erhalten wird.

**14.** Gyrometer **dadurch gekennzeichnet, daß** es der faseroptischen Meßvorrichtung (10) gemäß einem der Ansprüche 1 bis 13 entspricht, wobei der zu messende Parameter eine Komponente der Drehgeschwindigkeit des Ringinterferometers (20) ist.

**15.** Navigations- sowie Trägheitsstabilisierungssystem, das wenigstens ein Gyrometer gemäß Anspruch 14 aufweist.

**Claims**

**1.** A fiber-optic measurement device (10) of the type in which a parameter to be measured generates a phase difference $\Delta\Phi_p$ between two counter-propagating waves (24, 25), including:

- a light source (11),
- a fiber-optic SAGNAC ring interferometer (20), preferably single-mode, including a coil (21) and a splitting element (23), in which said two counter-propagating waves (24, 25) propagate, said ring interferometer (20) having a proper frequency $f_p$,
- an electromagnetic radiation detector (14), receiving the luminous power (37) exiting from said ring interferometer (20) and delivering a modulated electrical signal (38) representative of the luminous power (37), which is function of the total phase difference $\Delta\Phi_t$ between said two counter-propagating waves (24, 25) at the output of said ring interferometer (20),
- a modulation chain (30) adapted to modulate said luminous power (37) exiting from said ring interferometer (20), said modulation chain (30) including:

    - at least one digital / analog converter (31) adapted to process a digital control signal to deliver an analog control signal,
    - an amplifier (32) adapted to process said analog control signal to deliver a modulation control voltage $V_m(t)$,
    - at least one phase modulator (33) placed in said interferometer (20), which, when subjected at the input to said modulation control voltage $V_m(t)$, is adapted to generate at the output a phase-shift modulation $\Phi_m(t)$, said phase-shift modulation $\Phi_m(t)$ introducing between said two counter-propagating waves (24, 25) a phase-difference modulation $\Delta\Phi_m(t)$ such that: $\Delta\Phi_m(t) = \Phi_m(t) - \Phi_m(t-\Delta\tau_g)$, $\Delta\tau_g = 1 / (2 f_p)$ being the transit-time difference between said two counter-propagating waves (24, 25) determined between said phase modulator (33) and said splitting element (23), and

- signal processing means (110) including:

    - an analog / digital converter (111) digitizing said modulated electrical signal (38) received from the detector (14) and representative of said power received to deliver a digital electrical signal, and
    - a digital processing unit (112) adapted to process said digital electrical signal to deliver a signal function of said phase difference $\Delta\Phi_p$ and of said parameter to be measured,
    - feedback means (120) adapted to process said signal function of said phase difference $\Delta\Phi_p$ to generate a feedback signal,

- biasing means (130) adapted to generate a biasing signal,
- means (140) for controlling said modulation chain (30), adapted to process said feedback signal and said biasing signal to deliver said digital control signal at the input of said modulation chain (30), such that said modulation control voltage $V_m(t)$ at the input of said phase modulator (33) is the sum of a feedback modulation voltage $V_{cr}(t)$ and a biasing modulation voltage $V_b(t)$, said phase modulator (33) being adapted:

    - when it is subjected to said feedback modulation voltage $V_{cr}(t)$, to generate a feedback phase-shift modulation $\Phi_{cr}(t)$ (121), said feedback phase-shift modulation $\Phi_{cr}(t)$ (121) introducing a feedback phase-difference modulation $\Delta\Phi_{cr}$ between said two counter-propagating waves (24, 25) allowing to keep at zero the sum of said phase difference $\Delta\Phi_p$ and said feedback phase-difference modulation $\Delta\Phi_{cr}$, and
    - when it is subjected to said biasing modulation voltage $V_b(t)$, to generate a biasing phase-shift modulation $\Phi_b(t)$, , and

- means (150) for controlling the gain of said modulation chain (30) allowing to keep adjusted the transfer function of said modulation chain (30),
said fiber-optic measurement device (10) being **characterized in that** said biasing phase-shift modulation $\Phi_b(t)$ is the sum of:
- a first biasing phase-shift modulation component $\Phi_{b1}(t)$ (34A), introducing a fist biasing phase-difference modulation component $\Delta\Phi_{b1}(t)$ (34) between said two counter-propagating waves (24, 25), said first biasing phase-difference modulation component $\Delta\Phi_{b1}(t)$ (34) being a square-wave periodic modulation, of levels $+\pi$ and $-\pi$, at a first biasing modulation frequency $f_{b1}$ such that $f_{b1} = (2k_1+1) f_p$, $k_1$ being a natural integer and $f_p$ said proper frequency, and
- a second biasing phase-shift modulation component $f_{b2}(t)$ (35A), introducing a second biasing phase-difference modulation component $\Delta\Phi_{b2}(t)$ (35) between said two counter-propagating waves (24, 25), said second biasing phase-difference modulation component $\Delta\Phi_{b2}(t)$ (35) being a periodic modulation, of extreme amplitudes $+\pi/a$ and $-\pi/a$, a being a non-zero real number such that $|a| > 1$, at a second biasing modulation frequency $f_{b2}$ such that $f_{b2} = (2k_2+1) f_p$, $k_2$ being a non-zero natural integer such that $k_2 > k_1$, and $f_p$ said proper frequency.

2.	The fiber-optic measurement device (10) according to claim 1, wherein said first biasing phase-difference modulation component $\Delta\Phi_{b1}$(t) (34) has a duty factor of 50 %.

3.	The fiber-optic measurement device (10) according to claim 1, wherein said second biasing phase-difference modulation component $\Delta\Phi_{b2}$(t) (35) has a duty factor of 50 %.

4.	The fiber-optic measurement device (10) according to any one of claims 1 to 3, wherein $k_1 = 0$.

5.	The fiber-optic measurement device (10) according to any one of claims 1 to 4, wherein $k_2 > 2$.

6.	The fiber-optic measurement device (10) according to claim 5, wherein $k_2 > 4$.

7.	The fiber-optic measurement device (10) according to any one of claims 1 to 6, wherein said second biasing phase-difference modulation component $\Delta\Phi_{b2}$(t) (35) is a square-wave modulation.

8.	The fiber-optic measurement device (10) according to any one of claims 1 to 6, wherein said second biasing phase-difference modulation component $\Delta\Phi_{b2}$(t) (35) is a sine-wave modulation.

9.	The fiber-optic measurement device (10) according to any one of claims 1 to 8, wherein:

	- said second biasing modulation frequency $f_{b2} = (2k_2+1)f_p$ is such that $f_{b2} = (2k_{21}+1) f_{b1}$, $k_{21}$ being a non-zero natural integer, and $f_{b1} = (2k_1+1) f_p$ being the first biasing modulation frequency, and
	- said first biasing phase-difference modulation component $\Delta\Phi_{b1}$(t) (34) and said second biasing phase-difference modulation component $\Delta\Phi_{b2}$(t) (35) are in phase quadrature.

10.	The fiber-optic measurement device (10) according to any one of claims 1 to 9, wherein said feedback phase-shift modulation $\Phi_{cr}$(t) (121) is a stair-step modulation.

11.	The fiber-optic measurement device (10) according to claim 10, wherein said feedback phase-shift modulation $\Phi_{cr}$(t) (121) and said first biasing phase-difference modulation component $\Phi_{b1}$(t) (34A) are synchronous, each stair-step of said feedback phase-shift modulation $\Phi_{cr}$(t) (121) having a duration $Dt_g$ and said first biasing phase-shift modulation component $\Phi_{b1}$(t) (34A) being a first biasing modulation frequency $f_{b1}$ such that $f_{b1} = f_p$, $f_p$ being the proper frequency.

12.	The fiber-optic measurement device (10) according to any one of claims 1 to 11, wherein said feedback phase-shift modulation $\Phi_{cr}$(t) falls down by $2\pi$ when it exceeds $2\pi$.

13.	The fiber-optic measurement device (10) according to any one of claims 1 to 12, wherein:

	- said digital processing unit (112) demodulates said digital electrical signal in phase with said second biasing phase-difference modulation component $\Delta\Phi_{b2}$(t) (35) independently of the first biasing phase-difference modulation component $\Delta\Phi_{b1}$(t) (34), and
	- said means (150) for controlling the gain of said modulation chain (30) demodulate said digital electrical signal so as to provide a signal function of the transfer function of said modulation chain (30).

14.	A gyrometer, **characterized in that** it is compliant with the measurement device (10) of one of claims 1 to 13, the parameter to be measured being a component of the rotational speed of the ring interferometer (20).

15.	A navigation or inertial-stabilization system including at least one gyrometer according to claim 14.

## Fig.1
### ART ANTERIEUR

## Fig.2
### ART ANTERIEUR

## Fig.3
### ART ANTERIEUR

$\phi_{CR}(t)$

$2\pi$

$2\pi$

$\Delta\tau_g$

121

0

t

## Fig.4

$\Delta\phi_{b1}(t)$ , $\Delta\phi_{b2}(t)$

34

$+\pi$

$+\frac{\pi}{8}$

$\frac{1}{3}\Delta\tau_g$ $\frac{1}{3}\Delta\tau_g$

35

t1

0

t

t2

t'2

$-\frac{\pi}{8}$

$\frac{2}{3}\Delta\tau_g$

$\Delta\tau_g$

$\Delta\tau_g$

$-\pi$

$2\Delta\tau_g$

# Fig.5

# Fig.6

Fig.7

Fig.8

25

# Fig.9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0430747 A